# EUROPEAN PATENT APPLICATION

(11) **EP 3 674 440 A1**
(43) Date of publication of application: **01.07.2020**
(21) Application number: 19218221.0
(22) Date of filing: 12.02.2016
(51) Int. Cl.: C23C 16/54, C23C 14/56

(54) **VACUUM PROCESSING SYSTEM AND METHODS THEREFOR**

(62) Divisional of application: 16704830.5
(71) Applicant: Applied Materials, Inc., Santa Clara, CA 95054 (US)
(72) Inventor: Morrison, Neil, 64287 Darmstadt (DE); Henrich, Jürgen, 63694 Limeshain (DE); Ries, Florian, 63825 Westerngrund (DE); Stolley, Tobias, 61440 Oberursel (DE); Sauer, Andreas, 63762 Großostheim (DE); Buschbeck, Wolfgang, 63454 Hanau (DE)
(74) Representative: Zimmermann & Partner Patentanwälte mbB

(57) **Abstract**

A vacuum processing system (100) for a flexible substrate is provided. The vacuum processing system (100) includes a first chamber (110) adapted for housing a supply roll (111) for providing the flexible substrate; a second chamber (120) adapted for housing a take-up roll (121) for storing the flexible substrate (160) after processing; a substrate transport arrangement including one or more guide rollers (104) for guiding the flexible substrate from the first chamber (110) to the second chamber (120); a maintenance zone (130) between the first chamber (110) and the second chamber (120) wherein the maintenance zone (130) allows for maintenance access to or of at least one of the first chamber (110) and the second chamber (120); and a first process chamber (140) for processing the flexible substrate (10).

## Description

### TECHNICAL FIELD

Embodiments of the present disclosure relate to a vacuum processing system and methods of operating the vacuum deposition system. Embodiments of the present disclosure particularly relate to vacuum deposition systems and methods for processing flexible substrates. In particular, embodiments of the present disclosure relate to roll-to-roll vacuum deposition systems and a method of depositing at least two layers on a flexible substrate.

### BACKGROUND

Processing of flexible substrates, such as plastic films or foils, is in high demand in the packaging industry, semiconductor industries and other industries. Processing may consist of coating a flexible substrate with a desired material, such as a metal, in particular aluminum, semiconductors and dielectric materials, etching and other processing steps conducted on a substrate for the desired applications. Systems performing this task generally include a process drum, e.g., a cylindrical roller, coupled to a processing system for transporting the substrate, and on which at least a portion of the substrate is processed. Accordingly, Roll-to-roll (R2R) coating systems can provide a high throughput system.

Typically, a process, e.g. a physical vapor deposition (PVD) process, a chemical vapor deposition (CVD) process, and a plasma enhanced chemical vapor deposition (PECVD) process, can be utilized for depositing thin layers of metals which can be coated onto flexible substrates. However, Roll-to-Roll deposition systems are also experiencing a strong increase in demand in the display industry and the photovoltaic (PV) industry. For example, the use of touch panel elements, flexible displays and flexible PV modules results in an increasing demand for depositing suitable layers in Roll-to-Roll coaters, particularly with low manufacturing costs. However, such devices typically have several layers, which are typically manufactured with CVD processes and particularly also PECVD processes.

The arrangement of several CVD, PECVD and/or PVD sources in one or more process chamber(s) needs an excellent and efficient process. Commonly, the deposition of complex thin film layer structures is performed subsequently in different R2R coaters, each one designed to the needs of the special deposition technique. However, this concept results in high costs of ownership (CoO) for the manufacturing equipment.

Examples of products made of a coated substrate are OLED displays, which have received significant interest recently in display applications in view of their faster response times, larger viewing angles, higher contrast, lighter weight, lower power, and amenability to flexible substrates, as compared to liquid crystal displays (LCD). In addition to organic materials used in OLEDs, many polymer materials are also developed for small molecule, flexible organic light emitting diode (FOLED) and polymer light emitting diode (PLED) displays. Many of these organic and polymer materials are flexible for the fabrication of complex, multi-layer devices on a range of substrates, making these organic and polymer materials ideal for various transparent multi-color display applications, such as thin flat panel displays (FPD), electrically pumped organic lasers, and organic optical amplifiers.

Over the years, layers in e.g. display devices have evolved into multiple layers with each layer serving a different function. Depositing multiple layers onto multiple substrates may require multiple processing chambers. Therefore, there is a need in the art for an efficient method and apparatus for processing substrates in a flexible tool platform.

In view of the above, there exists a demand to provide a vacuum processing system and a method for mounting a vacuum processing system that overcomes at least some of the problems in the art.

### SUMMARY

In light of the above, a vacuum processing system for a flexible substrate and a method of depositing at least two layers on a flexible substrate are provided. Further aspects, advantages, and features of the present disclosure are apparent from the dependent claims, the description, and the accompanying drawings.

According to one aspect of the present disclosure, a vacuum processing system for a flexible substrate is provided. The vacuum processing system includes: a first chamber adapted for housing a supply roll for providing the flexible substrate; a second chamber adapted for housing a take-up roll for storing the flexible substrate after processing; a substrate transport arrangement including one or more guide rollers for guiding the flexible substrate from the first chamber to the second chamber; a maintenance zone between the first chamber and the second chamber, wherein the maintenance zone allows for maintenance access to or of at least one of the first chamber and the second chamber; and a first process chamber for processing the flexible substrate.

According to another aspect of the present disclosure, a use of the processing system as described herein for processing a flexible substrate, particularly for depositing a layer stack on the flexible substrate, is provided.

According to a further aspect of the present disclosure, a method of depositing at least two layers on a flexible substrate, particularly using a vacuum processing system as described herein is provided. The method of depositing at least two layers on a flexible substrate includes: guiding the flexible substrate over an outer surface of a process drum; providing a separation gas at at least two positions at opposing sides of at least a first deposition source; providing a process gas and exhausting the process gas between the at least two positions; and pumping at at least one vacuum outlet between the first deposition source and a at least one second deposition source.

The present disclosure is also directed to an apparatus for carrying out the disclosed methods and includes apparatus parts for performing each described method steps. These method steps may be performed by way of hardware components, a computer programmed by appropriate software, by any combination of the two or in any other manner. Furthermore, the disclosure is also directed to methods for operating the described apparatus. It includes method steps for carrying out every function of the apparatus.

### BRIEF DESCRIPTION OF THE DRAWINGS

So that the manner in which the above recited features of the present disclosure can be understood in detail, a more particular description of the disclosure, briefly summarized above, may be had by reference to embodiments. It is to be noted that the appended drawings illustrate only exemplary embodiments and are therefore not to be considered limiting of the scope of the present disclosure. In the drawings:
FIG. 1A shows a schematic perspective view of a vacuum processing system according to embodiments described herein;
FIG. 1B and 1C show schematic sectional views of a vacuum processing system according to embodiments described herein;
FIG. 1D shows a schematic top view of a vacuum processing system according to embodiments described herein;
FIG. 2 shows a schematic sectional view of a vacuum processing system according to embodiments described herein;
FIG. 3 shows a schematic sectional view of a process chamber of a vacuum processing system according to embodiments described herein;
FIGS. 4A and 4B show schematic views of a spreader roller device used according to embodiments described herein;
FIGS. 5A and 5B show schematic cross-sectional views of a substrate guide control unit according to embodiments described herein;
FIG. 6 shows a schematic sectional view of a process chamber of a vacuum processing system having a gas separation unit according to embodiments described herein;
FIG. 7A shows a schematic sectional view of a process chamber of a vacuum processing system having a gas separation unit according to embodiments described herein;
FIG. 7B shows a side view of a gas separation unit connected to a process drum and of a vacuum processing system according to embodiments described herein;
FIG. 8 shows a schematic view of a deposition source of a vacuum processing system according to embodiments described herein;
FIG. 9 shows a schematic view of a deposition source and a gas separation unit of a vacuum processing system according to embodiments described herein;
FIGS. 10A - 10C show schematic views of gas separation concepts of a gas separation unit according to embodiments described herein;
FIG. 11 shows a schematic perspective view of a deposition source of a vacuum processing system according to embodiments described herein;
FIGS. 12A and 12B show schematic views of a microwave antenna for a deposition source according to embodiments described herein;
FIG. 13 shows a schematic perspective view of a part of the process chamber of the vacuum processing system according to embodiments described herein;
FIG. 14 shows a schematic side view of a process drum of a vacuum processing system including a shutter device according to embodiments described herein;
FIG. 15 shows a schematic perspective view of components of a shutter device according to embodiments described herein;
FIG. 16 a detailed perspective view of a shutter device in different positions according to embodiments described herein,
FIG. 17 shows a plan view of a section of a vacuum processing system according to embodiments described herein;
FIG. 18 shows a block diagram illustrating a method for cleaning a process chamber of a vacuum processing system according to embodiments described herein; and
FIG. 19 shows a block diagram illustrating a method of depositing at least two layers on a flexible substrate.

### DETAILED DESCRIPTION OF EMBODIMENTS

Reference will now be made in detail to the various embodiments of the disclosure, one or more examples of which are illustrated in the figures. Within the following description of the drawings, the same reference numbers refer to same components. In the following, only the differences with respect to individual embodiments are described. Each example is provided by way of explanation of the disclosure and is not meant as a limitation of the disclosure. Further, features illustrated or described as part of one embodiment can be used on or in conjunction with other embodiments to yield yet a further embodiment. It is intended that the description includes such modifications and variations.

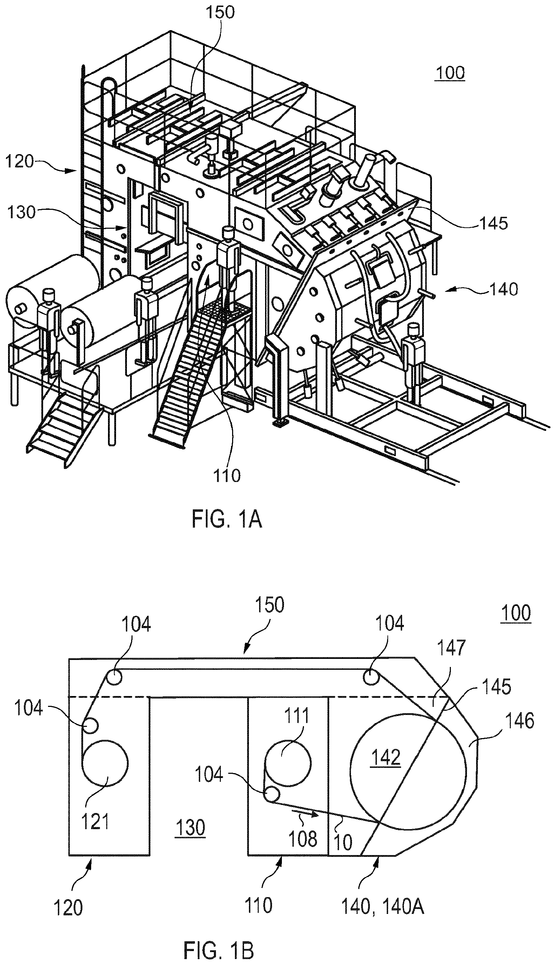

FIG. 1A shows a schematic perspective view of a vacuum processing system 100 for processing a substrate according to embodiments described herein. In particular, the vacuum processing system 100 may be adapted for guiding and processing a flexible substrate. For example, the vacuum processing system 100 may be configured for depositing, from a plasma phase, thin films onto a moving substrate, particularly a flexible substrate.

As exemplarily shown in FIGS. 1A and 1B, according to embodiments which can be combined with other embodiments described herein, the vacuum processing system 100 may include a first chamber 110, a second chamber 120, a maintenance zone 130, at least one process chamber, e.g. process chamber 140 in FIGS. 1A and 1B, and a passageway 150. For example, the first chamber 110 may be an unwinding chamber for housing a supply roll 111 for providing a substrate, particularly a flexible substrate 10. The second chamber 120 may be a winding chamber for housing a take-up roll 121 for storing the flexible substrate 10 after processing.

In the present disclosure, a "supply roll" should be understood as a roll on which a substrate, e.g. a flexible substrate, to be processed is stored. Accordingly, in the present disclosure, a "take-up roll" as described herein may be understood as a roll adapted for receiving the processed substrate. Further, it should be noted that the "supply roll" may also be referred to as "re-winder" and the "take-up roll" may also be referred to as "un-winder".

In the present disclosure, a "flexible substrate" may be characterized in that the substrate is bendable. For example, the flexible substrate may be a foil. In particular, it is to be understood that embodiments of the processing system as described herein can be utilized for processing any kind of flexible substrates, e.g. for manufacturing coatings or electronic devices on flexible substrates. For example, a substrate as described herein may include materials like PET, HC-PET, PE, PI, PU, TaC, one or more metals, paper, combinations thereof, and already coated substrates like Hard Coated PET (e.g. HC-PET, HC-TAC) and the like.

According to some embodiments, which can be combined with other embodiments described herein, the vacuum processing system may be configured for a substrate length of 500 m or above, e.g. of 900 m or above, e.g. 1000 m. The substrate width can be 300 mm or above, e.g. 400 mm or above, particularly 1400mm or above. Typically, the substrate thickness can be 50 µm to 200 µm.

Although embodiments described herein refer to the first chamber as an un-winding chamber and the second chamber as a winding chamber, it should be understood that the first chamber as referred to herein may be used as a winding chamber with a take-up roll and the second chamber may be used as an un-winding chamber with a supply roll.

According to embodiments, some of the chambers, or all chambers, of the vacuum processing system 100 may be adapted for a vacuum process. For instance, the processing system may include components and equipment allowing for generating or maintaining a vacuum in at least a part of the processing system, such as the first chamber, e.g. the un-winding chamber, the at least one process chamber and the second chamber, e.g. the winding chamber. According to some embodiments, the deposition system may include vacuum pumps, evacuation ducts, vacuum seals and the like for generating or maintaining a vacuum at least in parts of the deposition system. In some embodiments, each of the at least one process chamber(s), the winding chamber and the un-winding chamber may include vacuum generating devices and vacuum maintaining devices for generating and maintaining the vacuum in the individual chambers independently from the other chambers. For instance, each chamber may have individual corresponding vacuum pump or pumping station for evacuation of the respective area.

According to some embodiments, a chamber of the processing system being adapted for operating under vacuum conditions forms a vacuum tight enclosure, i.e. can be evacuated to a vacuum with a pressure of about 0.2 to 10 mbar or even to a vacuum with a pressure of 1^{∗}10⁻⁴ to 1^{∗}10⁻² mbar. Different pressure ranges are to be considered specifically for PVD processes, in the 10⁻³ mbar - range and CVD in the mbar - range, which are conducted in different pressure regimes. Further, the chamber(s) can be evacuated to a background vacuum with a pressure of 1^{∗}10⁻⁶ mbar or below. Background pressure means the pressure which is reached by evacuation of the chamber without any inlet of any gases. Contrary thereto, according to embodiments described herein, the maintenance zone provided between the first chamber 110 and the second chamber 120 is under atmospheric (i.e. ambient air) condition, such that an operator can use the maintenance access.

As exemplarily shown in FIGS. 1A and 1B, the first chamber 110 may be provided between the maintenance zone 130 and a first process chamber 140A. The maintenance zone 130 may be arranged between the first chamber 110, e.g. the un-winding chamber, and the second chamber 120, e.g. the winding chamber. Accordingly, the maintenance zone 130 being arranged between the first chamber 110 and the second chamber 120 allows for maintenance access of or to the first chamber and/or the second chamber, e.g. before, after or during operation of the vacuum processing system 100.

In the present disclosure, a "maintenance zone" as referred to herein should be understood as a zone allowing for maintenance of one or more chambers of the processing system. Accordingly, it is to be understood that the "maintenance zone" may be a service zone. For example, the maintenance zone may allow for monitoring, controlling, maintaining, cleaning, or exchanging components present in one or more of the chambers of the processing system. Further, the term "maintenance zone" may be understood as a zone allowing for maintenance performed by an operator. Accordingly, the maintenance zone as described herein may allow for maintenance access of or to a chamber. For instance, the maintenance zone may allow for accessing an un-winding chamber or a winding chamber as described herein. Maintenance access can include visual maintenance, access to electronic units for control of signals or receiving signals, or physical entry. According to some embodiments, the maintenance zone provides atmospheric conditions. In some embodiments, the maintenance zone may allow for controlling, cleaning or exchanging components present in one or more of the chambers of the processing system, to which the maintenance zone permits access. In some embodiments, the maintenance zone may offer access to control elements, such as switches, buttons, control dials, monitors, actuators, modulators and the like for influencing the process in the chambers of the processing system. In one example, the maintenance zone may have a switch for terminating the winding or un-winding process. In other or further embodiments, the maintenance zone may have control elements for controlling environmental conditions in the first and or second chamber, such as temperature, pressure, humidity, and the like. According to embodiments, the maintenance zone provides atmospheric conditions.

With exemplary reference to FIG. 1B, according to embodiments which can be combined with other embodiments described herein, the at least one process chamber (e.g. process chamber 140 in FIG. 1B), particularly a first process chamber 140A may be adjacently arranged to the first chamber 110, e.g. the un-winding chamber. The at least one process chamber may be provided with a process drum 142 for guiding the substrate during the process performed in the process chamber. The process drum 142 may be adapted for guiding the flexible substrate 10 past one or more process components present in the process chamber, such as one or more deposition sources. According to some embodiments, the process drum 142 can be configured to be heated and/or cooled to temperatures of about - 20°C to 400°C. Accordingly, the process drum may include heating and/or cooling channels.

In the present disclosure, a "process chamber" as described herein should be understood as a chamber in which a process takes place. For instance, in a process chamber, a deposition process may take place for depositing material on a substrate. However, a process chamber may also be adapted for alternative or additional processes as will be explained in detail below.

According to some embodiments, the at least one process chamber may house process components. In the present disclosure, a "process component" may be understood as a component for depositing material on the substrate and/or for heating the substrate and/or for cooling the substrate and/or for pre-treating the substrate and/or for etching the substrate or a layer disposed on the substrate and/or for cleaning the substrate and the like. Accordingly, in some embodiments, the process chamber may include a deposition source for depositing a material on the substrate, a heating device (such as a heating lamp, e.g. an infrared lamp), a cooling channel in the process drum, cleaning devices, pre-treatment devices such as devices for preparing the substrate for the process to be performed at a later stage, e.g. by a plasma pre-treatment, etching devices and the like. According to some embodiments, a pre-treatment plasma source, e.g. an RF plasma source can be provided to treat the substrate with plasma. For example, the pre-treatment with a plasma can provide for a surface modification of the substrate surface to enhance film adhesion of a film deposited thereon or can improve the substrate morphology in another manner to improve processing thereof. Accordingly, it is to be understood that a process chamber as described herein may be a CVD chamber, a PVD chamber, a PECVD chamber, a etch chamber or any other desired process chamber.

With exemplary reference to FIG. 1B, according to embodiments of the processing system as described herein, the substrate, e.g. a flexible substrate 10, may be guided along a substrate transport direction 108 from the supply roll 111 in the first chamber 110, e.g. the un-winding chamber, to a process drum 142 in the first process chamber 140A, further through the passage way 150 and to the take-up roll 121 in the second chamber 120, e.g. the winding chamber. As exemplarily shown in FIG. 1B, an arrangement of guide rollers 104 may be provided for guiding the flexible substrate from the supply roll 111 in the un-winding chamber to the take-up roll 121 in the winding chamber through at least one processing region in the process chamber 140 without contacting the front surface of the flexible substrate. During operation, the flexible substrate may be moved in the substrate transport direction into the at least one processing region in which, for example, a plasma deposition source may be arranged for transferring a deposition gas into a plasma phase such that e.g. a thin film may be deposited from the plasma phase onto the moving substrate. According to embodiments which can be combined with other embodiments described herein, one or more guide rollers of the transportation arrangement may be heated. In particular, a guide roller which is installed prior to the position at which the substrate is guided by the process drum through one or more processing regions may be configured to be heated. Accordingly, moisture mitigation from the substrate may be achieved through the use of a heated guide roller installed prior to the processing zone. Further, according to embodiments which can be combined with other embodiments described herein, the processing system may be provided with a trap (not shown), e.g. a cold trap, for collecting an outgassed vapor from the substrate, for example by using a heated guide roller. In particular, the trap for collecting an outgassed vapor from the substrate may be arranged at a position opposing the surface of the substrate from which the moisture may evaporate, e.g. due to heating of the substrate by a heated roller as described herein.

In the present disclosure, a "roll" or a "roller" may be understood as a device, which provides a surface, with which a substrate (or a part of a substrate) may be in contact during the presence of the substrate in the processing system. At least a part of the "roll" or "roller" as referred to herein may include a circular-like shape for contacting the substrate to be processed or already processed. In some embodiments, the "roll" or "roller" may have a substantially cylindrical shape. The substantially cylindrical shape may be formed about a straight longitudinal axis or may be formed about a bent longitudinal axis. According to some embodiments, the "roll" or "roller" as described herein may be adapted for being in contact with a flexible substrate. For example, a "roll" or "roller" as referred to herein may be a guiding roller adapted to guide a substrate while the substrate is processed (such as during a deposition process) or while the substrate is present in a processing system; a spreader roller adapted for providing a defined tension for the substrate to be coated; a deflecting roller for deflecting the substrate according to a defined travelling path; a processing roller for supporting the substrate during processing, such as a process drum, e.g. a coating roller or a coating drum; an adjusting roller, a supply roll, a take-up roll or the like. The "roll" or "roller" as described herein may comprise a metal. In one embodiment, the surface of the roller device which is to be in contact with the substrate may be adapted for the respective substrate to be coated. Further, it is to be understood that according to some implementations, the rollers as described herein may be mounted to low friction roller bearings, particularly with a dual bearing roller architecture. Accordingly, roller parallelism of the transportation arrangement as described herein can be achieved and a transverse substrate "wandering" during substrate transport may be eliminated.

In some embodiments, the guide rollers 104 guiding the flexible substrate 10 between the chambers of the processing system 100 as described herein, may also be configured for tension measurement. According to typical implementations of embodiments described herein, at least one tension measurement roller may be provided in the processing system. Beneficially, two tension measurement rollers on both sides of the process drum 142 may be provided which allow for tension measurement on the winding side and the unwinding side of the process drum. In particular, the tension measurement roller may be configured for measuring the tension of the flexible substrate. Accordingly, the substrate transport can be better controlled, the pressure of the substrate on the process drum can be controlled and/or damage to the substrate can be reduced or avoided.

According to some embodiments, which can be combined with other embodiments described herein, the supply roll and the take-up roll, the guide rollers for guiding the substrate, the process drum, and other rolls or elements in the processing system being in contact with the flexible substrate are positioned and/or arranged in the processing system such that only the back side of the flexible substrate is contacted, i.e. the side which is not processed (or not to be processed) in the processing system. Thus, there is no roller based substrate front surface contact when un-winding, processing, re-winding, tensioning or guiding the substrate. This reduces contamination on the processed substrate surface, but also on the substrate surface to be processed. Accordingly, the risk of substrate damage especially on the processed surface is reduced.

According to embodiments, which can be combined with other embodiments described herein, the guide rollers 104 for guiding the flexible substrate may have a minimum wrapping angle of 13°, particularly of 15° or above. Accordingly, minimum wrapping angle relates to the fact that the enlacement varies depending on and between the two operation conditions when the supply roll 111 and the take-up roll 121, respectively, are empty or filled entirely with a substrate.

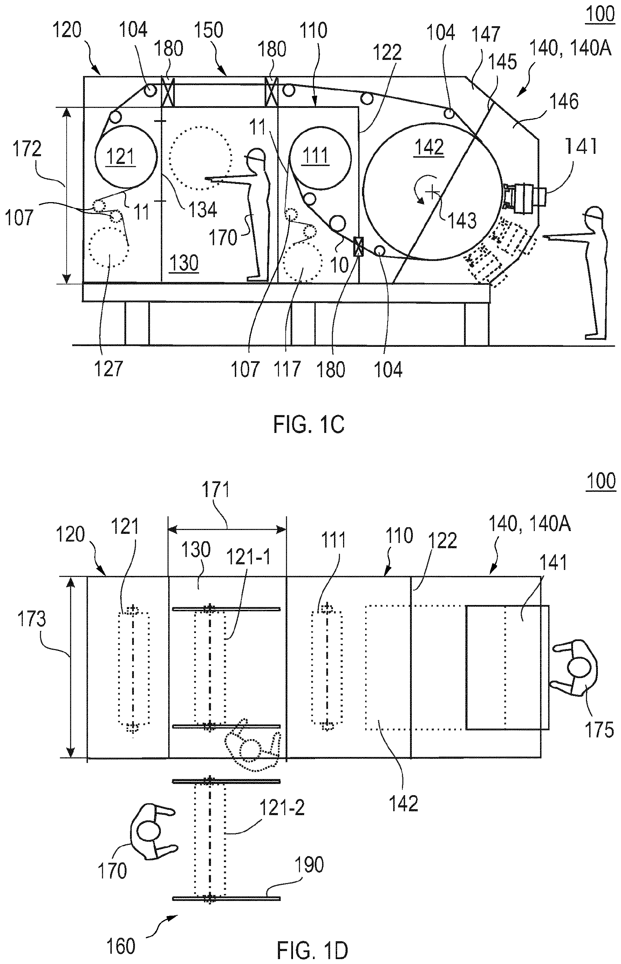

According to embodiments which can be combined with other embodiments described herein, the process drum 142 is rotatable with respect to a longitudinal axis, particularly the rotation axis 143 of the process drum 142, as exemplarily shown in FIG. 1C. The process drum may have a curved outer surface for guiding the substrate along the curved outer surface. Accordingly, the flexible substrate 10 may be transported and processed by being moved over the rotating process drum 142. According to embodiments, the processing of the flexible substrate 10 may be effected, for example, but not limited thereto, by performing coating, plating, or a laminating process on a portion of flexible substrate 10, which may be positioned onto the process drum 142. According to some embodiments, the wrapping angle of the substrate around the process drum 142 may be less than 180°, particularly less than 170°, more particularly less than 150°.

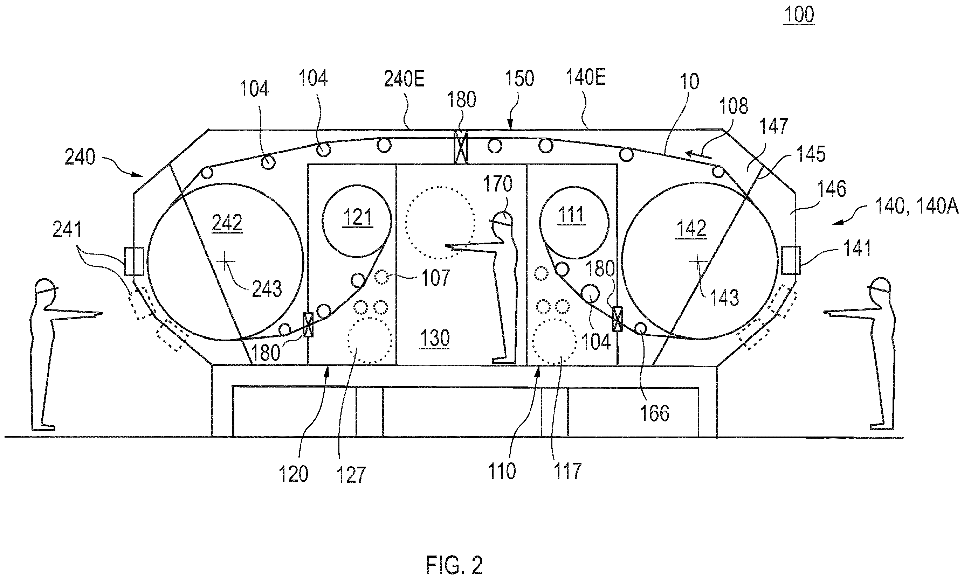

According to embodiments which can be combined with other embodiments described herein, the sum of the wrapping angles of all the rolls present in the processing system can be between 180° and 540°, for example between 180° and 360°. In some embodiments, e.g. if a second process drum is provided as exemplarily shown in FIG. 2, the sum of the wrapping angles of all rolls being present in the deposition system (except the supply roll and take-up roll) may be equal to or below 540°. In some embodiments, the sum of the wrapping angles of all rolls being present in the deposition system (except the supply roll and take-up roll) may be below 360°. Typically, the number of guiding rollers is 2 or above and 10 or below, especially when a low total wrapping angle (such as a wrapping angle of below 360°) is desired.

It is to be understood that the single components in the processing system, such as the guiding rolls, the supply roll, the take-up roll, the process drum and the process components, e.g. deposition sources or etching devices, can be adapted for a flexible substrate, e.g., a web or a foil, or a glass substrate. For instance, the guiding rolls and/or the supply roll and/or the take-up roll and/or the process drum may have respective surfaces and geometries for guiding, un-winding, or winding the flexible substrate.

With exemplary reference to FIGS. 1A and 1B, according to embodiments which can be combined with other embodiments described herein, the passageway 150 may be configured for connecting the first process chamber 140A with the second chamber 120, e.g. the winding chamber, in which the processed substrate may be wound on the take-up roll 121. For example, the passageway 150 may be arranged above the first chamber 110 and/or the second chamber 120. In other embodiments, the passageway may be formed as a tunnel located below the first chamber 110 and/or the second chamber 120. The passageway 150 (or the tunnel) may be used to guide the substrate from the first process chamber 140A to the second chamber 120, e.g. the winding chamber. According to some embodiments, the passageway or tunnel may be adapted for guiding the substrate under vacuum conditions, e.g. by providing respective seals, pumps, sluices and the like. In some embodiments, the passageway may be under atmospheric conditions during operation of the deposition system. Operating the passageway under atmospheric conditions may save cost and effort. According to some embodiments, sluices may be provided in the passageway, such as one gap sluice 180 at the position where the substrate enters the passageway from the process chamber and one gap sluice 180 where the substrate exits the passageway to the winding chamber.

Yet further additionally or alternatively, the tunnel or passageway may be adapted for generating and/or maintaining a vacuum therein. However, according to some embodiments, the passageway or the tunnel may be understood as being a part of the process chamber. For instance, the tunnel may not be separated from the process chamber by sluices. Thus, the tunnel may for instance be provided with the same vacuum as present in one, or both, of the process chambers. In one example, the tunnel may provide vacuum conditions being generated and maintained by the same vacuum generating means as one or both process chambers.

In some embodiments, the tunnel or passageway may be adapted for being operated under vacuum conditions and/or optional controlled inert atmosphere. Alternatively, the tunnel or passageway may be operated under atmospheric, or ambient, conditions.

In some embodiments, the passageway or tunnel being provided for guiding the substrate from one chamber to another chamber of the deposition system, may be equipped with adaption devices for providing measuring devices such as temperature sensors, pressure sensors, tension sensors for the substrate, visual control devices, substrate control devices and the like.

In some embodiments, the passageway (or tunnel), the first chamber and the second chamber encompass the maintenance zone. In one example, the passageway may be provided in, by or as a topside lid, which extends above the maintenance zone. In another example, as mentioned above, the passageway may be provided in, by or as a bottom side tunnel extending below the maintenance zone.

According to some embodiments, the at least one process chamber may be adapted to allow deposition of a material on the substrate in a direction bottom-up or horizontally. For example, the processing system as described herein may be employed as a deposition system which can be provided with bottom-up deposition sources such that particle generation on the substrate is avoided. In the present disclosure, "bottom-up deposition sources" may be understood as a configuration in which the deposition sources are arranged at the height of or below a rotation axis 143 of the processing drum 142, as exemplarily shown in FIG. 1C.

With exemplary reference to FIGS. 1B and 1C, according to embodiments which can be combined with other embodiments described herein, the process chamber 140 may include an inclined flange 145. In some embodiments, the process chamber 140 may be divided in at least two parts being connected by the inclined flange 145 and forming the process chamber 140 when assembled. As exemplarily shown in FIG. 1B, a first part 146 of the process chamber 140 may be connected to a second part 147 of the process chamber 140 by the inclined flange 145, particularly with respect to the vertical. The first part 146 of the process chamber 140 may house (at least partially) a plurality of processing components being arranged about the process drum 142. For instance, FIG. 1C shows one processing component of the one or more processing components 141, such as a deposition source with two further deposition sources being indicated by dashed lines. According to some embodiments processing component, e.g. a deposition source, may be mounted to a drive on an atmospheric side of the process chamber in order to control and adjust a position of the processing component in the process chamber. For example, the drive may be a linear actuator configured to provide a strike of up to 30 mm.

It is to be understood that according to some embodiments, which can be combined with other embodiments described herein, two or more processing components, e.g. deposition sources can be provided. For example, four, five, six, or even more, such as 8, 10 or 12 processing components, e.g. deposition sources, can be provided. The processing component may be provided in respective processing regions, and the substrate being supported by the process drum 142 may be processed in the respective processing regions.

According to embodiments which can be combined with other embodiments described herein, the first part 146 of the process chamber 140 may be adapted so that processing components (such as deposition sources or tools) may externally be attached to the first part 146. The second part 147 of the process chamber 140 may be configured for being connectable to the passageway 150, for example by being in communication with the passageway 150, or by being even a part of the passageway (as for instance shown in FIG. 1C).

According to some embodiments described herein, the inclined flange 145 of the process chamber 140 may provide a separation wall within the process chamber for separating processing regions in the process chamber. For instance, the inclined flange 145 shown in the figures may indicate a vacuum tight separation wall within the process chamber 140. In one example, the vacuum tight separation wall within the first process chamber 140A may provide a sluice or the like for passing through of the substrate. By providing a separation wall within the process chamber 140, the risk of contamination may be reduced, in particular when separating a region of the process chamber, in which a deposition takes place, from a region in the process chamber, in which the substrate is only guided or in which a pre-treatment or post-treatment takes place.

The inclined flange 145 of the process chamber 140 may allow arranging processing components 141, e.g. deposition sources, below the substrate to be processed. Thus, in the case that a deposition process is performed in the process chamber, the deposition may take place from below the substrate and not from above the substrate. In some embodiments, the deposition may be performed from the horizontal direction to the substrate, as exemplarily shown in FIG. 1C. According to some embodiments, the deposition sources may be provided at the lower half of the process drum 142. Accordingly, beneficially no deposit down, i.e. with a source orientation above the horizontal center line of the process drum 142, or the rotation axis 143 of the process drum 142, is used for the processing system according to embodiments described herein. In particular, according to embodiments described herein, an arrangement of deposition sources may be provided at the height or below the height of the rotation axis 143 of the process drum 142. Accordingly, generated particles, which could contaminate the substrate and the process, remain in the deposition source due to gravitation, such that generation of undesired particles on the substrate and/or within a deposited layer can be avoided.

Accordingly, with exemplarily reference to FIGS. 1B and 1C, according to embodiments which can be combined with other embodiments described herein, the outer shape of the process chamber 140 may be adapted for a bottom-up arrangement of process components, e.g. deposition sources. For instance, the outer shape of the process chamber 140 may have a segmented shape taking into account the position of each process component arranged in the process chamber 140. In some embodiments, the outer shape of the chamber may have a bent or a polygonal-like shape, as exemplarily shown in FIGS. 1B and 1C.

According to some embodiments, the process chamber may include one or more support device(s) for supporting or holding a processing component in the process chamber. In some embodiments, the support device may be suitable for holding a process component in a fixed position for a predetermined time interval and within predetermined tolerances. In one example, the process chamber may include a support device for supporting or holding the above described process components, such as a deposition source for depositing a material on the substrate, a heating device (such as a heating lamp, e.g. an infrared lamp), cleaning devices and pre-treatment devices such as devices for preparing the substrate for the process to be performed at a later stage. In some embodiments, the support device may include a clamping device, a gripping device, a table, fixtures, carriers, fasteners, attachment devices, adapter equipment and the like.

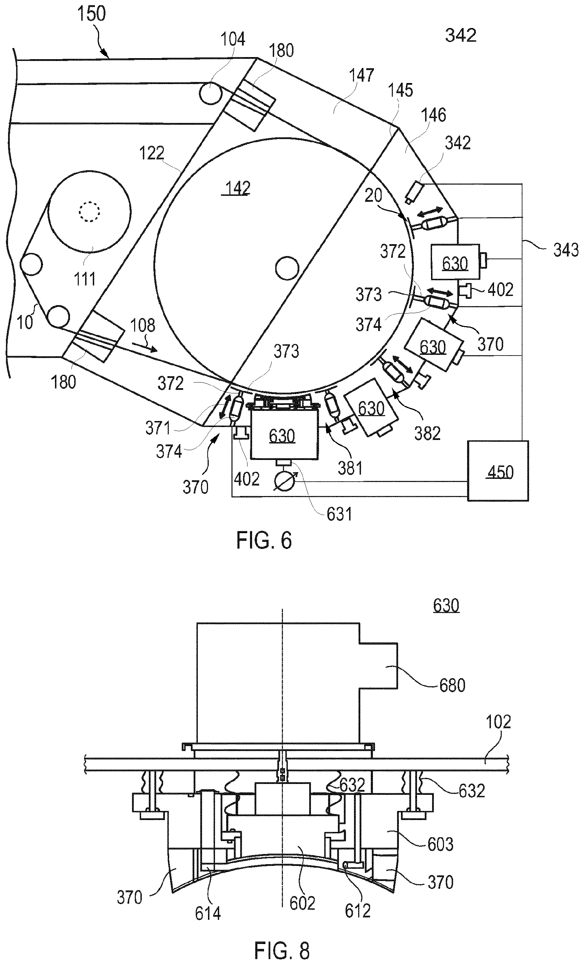

According to yet further embodiments, which can be combined with other embodiments described herein, a process chamber of the deposition system can have compartments or openings, wherein process components, such as deposition sources or deposition stations having deposition sources can be positioned in respective openings or respective compartments such that the different kinds of deposition sources are separated within a process chamber, as exemplarily described in more detail later with reference to FIG. 6.

FIG. 1C shows a more detailed view of the processing system 100 as schematically shown in FIG. 1B. As exemplarily shown in FIG. 1C, in some embodiments, the flexible substrate 10 may be guided through a slit or an opening in the wall separating the chambers of the processing system, e.g. through a slit or an opening in the separation wall 122 between the first chamber 110 and the process chamber 140. For example, the slit may be adapted for guiding the substrate from one vacuum chamber to another vacuum chamber. In other embodiments, the slit or opening may include sealing elements in order to separate, at least substantially, the pressure conditions of the two chambers linked by the slit. For instance, if the chambers being linked by the slit or opening provide different pressure conditions, the slit or opening in the wall is designed so as to maintain the respective pressure in the chambers.

According to embodiments described herein, at least one gap sluice, e.g. gap sluice 180, or load lock valve for separating the first chamber 110 or un-winding chamber from the process chamber 140 is provided at a separation wall 122, as exemplarily shown in FIG. 1C. The at least one gap sluice may be configured such that the flexible substrate can move therethrough and the gap sluice can be opened and closed for providing a vacuum seal. According to embodiments which can be combined with other embodiments described herein, the gap sluice 180 may include a roller for guiding the substrate, e.g. for redirecting the substrate movement by an angle of 10° or above. Further, an inflatable seal may be provided that can be pressed against the roller of the gap sluice. Accordingly, the gap sluice may be closed by inflating the seal and the first chamber 110 and the process chamber 140 are separated from each other in a vacuum tight manner. Thus, for instance the first chamber 110 can be vented while the process chamber 140 can be maintained under technical vacuum.

According to a further alternative implementation, the gap sluice or load lock valve can also be provided without a roller. An inflatable seal can press the substrate against a flat sealing surface. Yet, also other means for selectively opening and closing the gap sluice can be utilized wherein opening and closing, i.e. having an open substrate path and a vacuum seal, can be conducted while the substrate is inserted. The gap sluice for closing the vacuum seal while the substrate is inserted allows for particularly easy exchange of the substrate, as the substrate from the new roll can be attached to the substrate from the previous roll.

Although the gaps, openings or gap sluices are described with respect to guiding the flexible substrate from the first chamber to the process chamber, the gaps, openings or gap sluices as described herein may also be used between other parts of the processing system, such as between the process chamber 140 and the passageway 150, between the passageway 150 and the second chamber 120, and/or between a further process chamber, e.g. a second process chamber 240 as shown in FIG. 2, and the second chamber 120.

As exemplarily indicated by the dotted lines in the first chamber 110 and the second chamber 120 in FIG. 1C, according to some embodiments, the vacuum processing system 100 may include an interleaf module for example in a case in which the flexible substrate 10 to be processed is provided on the supply roll 111 together with an interleaf 11. Accordingly, the interleaf can be provided between adjacent layers of the flexible substrate such that direct contact of one layer of the flexible substrate with an adjacent layer of the flexible substrate on the supply roll 111 can be avoided. For instance, the un-winding chamber may be equipped with a first interleaf module for taking up an interleaf provided for the protection of the substrate on the supply roll 111. The interleaf module may include some interleaf guiding rolls 107 for guiding the interleaf to an interleaf take-up roll 117 upon un-winding the flexible substrate with the interleaf from the supply roll 111. Accordingly, the winding chamber may also include an interleaf module including interleaf guiding rolls 107 for guiding the interleaf 11 supplied from an interleaf supply roll 127 to the take-up roll 121. Accordingly, the second interleaf module may provide an interleaf, which is wound on the take-up roll 121 together with the processed substrate for protecting the processed substrate on the take-up roll 121. It is to be understood that the first chamber 110 and the second chamber 120 may be provided with holdings and/or receptions for mounting the interleaf take-up roll 117 and the interleaf supply roll 127, respectively, as well as holdings and/or receptions for mounting the respective interleaf guiding rolls.

FIG. 1D shows a schematic top view of the deposition system 100 as shown in FIG. 1C. In the examples of FIGS. 1C and ID, the operator 170 is changing the take-up roll 121 of the second chamber 120, through the maintenance zone 130. It is to be noted that the take-up roll 121 is shown in dashed lines in different positions. According to some embodiments, a control signal may inform the operator 170 about the necessity to change the take-up roll 121 in the second chamber 120. As can be seen in FIGS. 1C and ID, the maintenance zone 130 offers a good accessibility for exchanging the take-up roll 121.

According to some embodiments, the processing system as described herein may allow exchanging components in the processing system in an easy and uncomplicated way, as can be seen in FIG. 1D. On the right side of FIG. ID, the process chamber 140 with the process drum 142 (dashed lines) is illustrated. The operator indicated with reference number 175 in FIG. 1D may have access to processing components 141, such as to deposition sources. According to some embodiments, the one or more processing components 141 may be grouped together so that the one or more processing components may be accessed as one unit or one group (e.g. a group being formed with the first part of the process chamber, as explained above with respect to the inclined flange). According to other embodiments, the individual processing components may be accessed one by one. The processing components 141 may be exchanged, e.g. in the case that the processing components are worn or consumed, or if the process should be changed. For instance, the process system according to embodiments described herein may provide the option to change the substrate width. An easy access and an easy exchange of processing components may be helpful for efficiently using the process system for different process types or different substrates.

According to some embodiments, the maintenance of the supply roll and the take-up roll in the form of removing, exchanging, or providing the supply roll or the take-up roll, i.e. maintenance task for which one or more of the winding chambers are vented and/or opened may be performed while the substrate remains in the one or more process chambers. According to some embodiments, the processing action of the processing system is stopped and the substrate transport rollers are inactivated. The substrate may then be clamped in by vacuum tight valves or gap sluices between the process chamber and the winding/ un-winding chamber, such as by clamping the substrate in by an inflatable seal between the process chamber and the winding/ un-winding chamber. In some embodiments, the substrate is cut in the winding/ un-winding chamber after being clamped between the process chamber and the winding/un-winding chamber. The supply roll and/or the take-up roll are removed and/or exchanged. A newly added substrate being provided by a supply roll may be fixed (such as adhered or glued) to the cut end of the substrate in the un-winding chamber. In this case, the one or more of the winding chambers are vented and/or opened while the one or more process chambers are kept under vacuum and maintenance is performed in the winding/ un-winding chamber while vacuum is kept in other parts of the processing system.

According to some embodiments, the maintenance zone 130 may be adapted for typical maintenance steps of the first chamber, the second chamber and/or even the tunnel above the first and/or second chamber. For instance, the size of the maintenance zone 130 may be adapted to the size of an operator 170, as exemplarily shown in FIG. 1C. Further, the size of the maintenance zone 130 may be chosen so that the operator may remove the supply roll and/or the take-up roll from the first and the second chamber. According to some embodiments, the maintenance zone may have a length 171 (as can be seen in FIG. ID) of more than 1 m. According to some embodiments, the maintenance zone may have a length 171 of typically between about 1 m and about 3 m, more typically between about 1.5 m and about 2.5 m and even more typically between about 1.5 m and about 2 m. Further, the maintenance zone may have a height 172 (as can be seen in FIG. 1C) of more than 1.7 m. According to some embodiments, the maintenance zone may have a height 172 of typically between about 1.7 m and about 3 m, more typically between about 2 m and about 3 m and even more typically between about 2 m and 2.5 m. Further, the maintenance zone 130 may have a depth 173 (as can be seen in FIG. ID) dependent on the substrate width. In some embodiments, the depth 173 of the maintenance zone 130 may be more than 0.7 m. According to some embodiments, the depth 173 of the maintenance zone may be typically between about 1.0 m and about 4.0 m, more typically between about 2 m and about 3.5 m and even more typically between about 2 m and about 3 m.

As indicated by a take-up roll in a position 121-1 with dashed lines in FIG. ID, the maintenance zone allows the operator 170 to handle the take-up roll removed from the second chamber 120. According to some embodiments, the size of the maintenance zone 130 may be a compromise between easy access to the chambers for maintenance purposes and the space available for the deposition system. In some embodiments, the guide roller system in the deposition system as described herein, and especially the number of guide rollers, is adapted to the size of the maintenance zone.

In some embodiments, the maintenance zone 130 allows for maintenance access to or of at least one of the first chamber 110 and the second chamber 120 during operation, e.g. while the process chamber 140 is evacuated to a pressure of 10 mbar or below. For instance, maintenance access may be provided during operation in the form of serving or activating control elements, or in the form of visual control, or the like. However, it should be understood that the maintenance of the supply roll 111 and the take-up roll 121 in the form of removing, exchanging, or providing the supply roll 111 or the take-up roll 121, i.e. maintenance task for which one or more of the winding/ un-winding chambers are vented and/or opened cannot be performed during the operation, i.e. processing action, of the processing system. However, the maintenance zone, which allows for the maintenance access for maintenance of the supply roll 111 and the take-up roll 121 in the form of removing, exchanging, or providing the supply roll or the take-up roll, and/or for cleaning of the interior of one or more of the vacuum chambers adjacent to the maintenance zone 130 remains at atmospheric pressure also when the one or more process chambers, which may be vented and/or opened for maintenance access, are evacuated, e.g. to a pressure of 10 mbar or below.

In some embodiments, the maintenance zone 130 is provided and configured so that the first chamber 110 and/or the second chamber 120 can be accessed from a radial direction of the first chamber 110 and from a radial direction of the second chamber 120, respectively. The maintenance zone 130 allows for accessing the first chamber 110 and/or the second chamber 120 from the radial direction of the supply roll 111 and take-up roll 121, respectively. The radial direction of a chamber may correspond to the radial direction of one of the supply roll or take-up roll in one embodiment. According to some embodiments, the maintenance zone allows for accessing the first chamber and/or the second chamber from the radial direction of a winding shaft for the supply roll and the take-up roll, respectively. Particularly, the maintenance zone can allow for accessing the first chamber (see e.g. 110 in FIG. 1B), e.g. the vacuum chamber with the supply roll, and for accessing the second chamber (see e.g. 120 in FIG. 1B), e.g. the vacuum chamber with the take-up roll, from a respective first radial side and a respective second radial side, wherein the first radial side and the second radial side face each other. For example, a supply roll can be removed radially towards the take-up spool and vice versa.

According to embodiments described herein, the maintenance zone allows for maintenance access. Maintenance access can include visual maintenance (such as visual control), access to electronic units for control of signals or receiving signals, or physical entry. In one example, the maintenance access may be provided by a door, a window or an opening that can be closed by, e.g., a lid. According to some embodiments, the maintenance access may be provided by a chamber wall, such as a window in a wall of the winding or un-winding chamber.

In some embodiments, the maintenance zone may provide maintenance access through a window in a chamber wall, as shown in FIG. 1C as inspection window 134, indicated by two horizontal lines. The inspection window being exemplarily shown in the wall of the second chamber 120 may be arranged at a height that allows the substrate to be viewed, e.g. when wound on the take-up spool, or when un-wound from the supply spool. According to some embodiments, the inspection window may have a size for viewing the complete width of the flexible substrate, such as a width of typically between about 1 m and about 3 m, more typically between about 1.2 m and about 2.5 m, and even more typically between about 1.4 m and about 2.4 m. According to yet further embodiments, the inspection window may have a size for viewing the complete winding and/or un-winding process, e.g. by allowing for seeing the complete supply roll and/or the complete take-up roll. In some embodiments, the inspection window of the maintenance zone may be composed of several inspection ports that together enable the operator to have an impression of the processes in the chambers.

According to some embodiments, the maintenance zone may offer access to the first and/or second chamber, e.g. in the form of a door in a chamber wall. One or more doors may be adapted for reaching components in the first and/or second chamber, e.g. for reaching the supply roll or the take-up roll. In some embodiments, a door may include the inspection window of a chamber. According to some embodiments, which may be combined with other embodiments described herein, a door may allow an operator to enter the first and/or second chamber.

In some embodiments, an illuminating device may be provided in the first chamber and/or the second chamber. In particular, the illuminating device may be arranged in the first and/or second chamber so that the substrate to be processed, or the processed substrate, may be illuminated from one side, such as either the processed side or the non-processed side (or either the side to be processed or the side not to be processed). For instance, the illuminating device may facilitate the inspection and visual control of the substrate, which may be - as described above - performed through the maintenance zone, and in particular by a window in the chamber wall, such as inspection window 134. In some embodiments, the illuminating device is a lamp.

In FIG. ID, a schematic drawing of a loading- and un-loading system 160 for the supply roll 111 and the take-up roll 121 is shown. According to some embodiments, an integrated loading- and unloading system may be provided for the processing system as described herein. In some embodiments, the loading- and un-loading system may include a table 190 and a move-in/out device for the take-up roll 121 and/or the supply roll 111. In the example shown in FIG. ID, the moving out of the take-up roll 121 is shown. For instance, the move-in/out device may be inserted by the operator 170 into the first chamber 110 in order to grip the take-up roll 121 to be exchanged or removed. The move-out device gripping the take-up spool may be retracted from the first chamber 110 and may remove the take-up roll 121 from the second chamber 120. In one example, the move-out device may include gripping devices for gripping the take-up roll at both ends thereof to remove take-up roll from the roll support, which may, for instance, be a rotatable axle. According to some embodiments, the move-in/out device may be adapted so that the take-up roll may be removed from the second chamber without contacting the substrate wound on the take-up roll.

As can be seen in FIG. ID, when the take-up roll 121 is removed from the second chamber 120, the take-up roll 121 is loaded on the table 190 of the substrate handling system in position 121-1 in the maintenance zone 130. The table 190 may be a lifting table, and in particular, a center lifting table. The operator 170 may move within the maintenance zone 130 so as to move the table 190 with the take-up roll on it, e.g. in position 121-1. The table 190 may then be removed from the maintenance zone 130 to bring the take-up roll out of the maintenance zone 130 in position 121-2. The operator 170 can thus move the take-up roll in an easy and uncomplicated way.

According to some embodiments, the substrate handling system may include alternatives to the table. For instance, a gripping tool may be used for moving the take-up roll out of the maintenance zone. In further embodiments, the take-up roll may be carried by a shaft, a support, or the like allowing the operator to handle the take-up roll. According to some embodiments, the alternatives to the lifting table may be used in the case that a tunnel extending below the maintenance zone 130 is used instead of a passageway 150 extending above the maintenance zone 130.

Generally, although only the process of changing the take-up spool is described, the maintenance zone also offers a good accessibility for substrate feed-in and feed-out between the coating processes. Thus, also the supply roll 111 may be exchanged in the way shown in FIG. 1D.

In some embodiments, the lifting table may form a central lifting table for loading and un-loading the substrate to and from the deposition system. The table may include a substrate support for holding the take-up roll or the supply roll together with the substrate. According to some embodiments, the lifting table may be movable between at least an upper position and a lower position. The substrate on the take-up roll being arranged in or on the substrate support may be moved out of the maintenance zone in a lower position of the lifting table. When the substrate and the lifting table are moved out of the maintenance zone (as indicated in position 121-2 of the take-up roll), the take-up roll together with the substrate may further be transported by a crane, such as an indoor-crane or overhead crane, or may be lifted, e.g., by means of a crane, such as a gantry crane or the like being part of the processing system, to a transport vehicle.

By using the loading- and un-loading system as described herein, no moveable un- and re-winders (such as un- and re-winding devices being present within the first and second chamber during processing) are used in the deposition system according to embodiments described herein. The tools for moving and gripping the rolls can be introduced in the first and second chamber from the maintenance zone. According to further embodiments, the substrate handling system may include an integrated portal crane for lifting the roll to be removed from a chamber, e.g. in the case that the processing system uses a tunnel for transporting the substrate within the processing system.

However, by using the processing system in a design having a passageway above the maintenance zone, according to embodiments described herein, no overhead crane is used for removing the substrate from the deposition system, which saves cost and space for the user of the deposition system. Thus, the processing system according to embodiments described herein may also be used in smaller (or lower) factory buildings than systems known in the art. Also, the deposition system does not make high demands on the environment by not using an overhead crane.

It should be understood that the process of removing a roll from a chamber as described above may also be performed in reverse order, when delivering a new supply or take-up roll to the chambers.

According to some embodiments, the processing system may include a control unit for controlling the parameters in the vacuum processing system. For example, the control unit can be a controller or a control interface, which is provided outside the chambers of the processing system. In some embodiments, the control unit may be connected to sensors in the individual chambers of the processing system and/or to deposition sources, the supply roll, the take-up roll and the like. Accordingly, the control unit may be able to calculate desired measures in the processing system. For instance, the control unit may indicate when a change of a supply roll or a take-up roll is to be performed, e.g. via the maintenance zone. The control unit may also be able to generate an alert in the case of failure of a component in the deposition system.

According to some embodiments, the processing system as described herein may have a modular design. For instance, the processing system as exemplarily shown in FIGS. 1A to 1D may be adapted so that a second process chamber may be connected, e.g. adjacent to the first chamber. Accordingly, the processing system may be provided with flanges or connection bases allowing for expanding the processing system by connecting further chambers to the processing system. For example, the second chamber 120, or winding chamber, may include connections and the like for mounting a second process chamber 240 adjacent to the second chamber or winding chamber, as exemplarily shown in FIG. 2. Accordingly, it is to be understood that further chambers may be provided for extending the operation range of the processing system. Accordingly, the modular design of the processing system as described herein allows for adapting the size in the base shape which fits to the needs and requirements of the user, e.g. space requirements in a factory.

According to some embodiments of the processing system, the first process chamber 140A may be arranged adjacent to the first chamber 110 or un-winding chamber, whereas the second process chamber 240 may be arranged adjacent to the second chamber 120 or winding chamber. In particular, the second process chamber 240 may be located so that the second chamber 120 is provided between the maintenance zone 130 and the second process chamber 240, as exemplarily shown in FIG. 2.

In the embodiment shown in FIG. 2, the flexible substrate 10 to be processed is unwound in the un-winding or first chamber 110. Via guide rollers (e.g. guide roller 104), the flexible substrate 10 is guided to the first process chamber 140A of the processing system. For processing the flexible substrate 10 in the first process chamber 140A, the substrate may be guided by the process drum 142. The process drum 142 may be rotatable. The first process chamber 140A may include processing components 141 past which the substrate is guided while being guided by process drum 142. For instance, the processing components 141 may include at least one deposition source. In the embodiment shown in FIG. 2, only one deposition source is shown in the first process chamber 140A, while other deposition sources of the first process chamber are shown in dashed lines.

Although in the embodiment shown in FIG. 2, the first chamber 110 is described as being an un-winding chamber and the second chamber 120 as being a winding chamber, the deposition system according to embodiments described herein is not limited to this arrangement. In an alternative embodiment, the first chamber 110 may be the winding chamber and the second chamber may be the un-winding chamber.

According to some embodiments, the second process chamber 240 may be configured similarly to the first process chamber 140 as described herein. Accordingly, the second process chamber 240 may include a second process drum 242 with a second rotation axis 243 and one or more second processing components 241, as exemplarily shown in FIG. 2. It is to be understood that the second process chamber may include some or all components as described with respect to the first process chamber as described herein. Accordingly, the second process chamber 240 may include an inclined flange, a first part and a second part with all their features and advantages as described with respect to the first process chamber 140A.

As can be seen in FIG. 2, the processing system according to embodiments described herein provides the possibility to assemble the processing system in a modular manner. For instance, the processing system may be adapted to special requirements of a process to be performed, for example by mounting an additional second process chamber, e.g. second process chamber 240, to a processing system 100 as described above with respect to FIGS 1A to 1D. Accordingly, more different processes may be combined within the processing system, e.g. by adding a second process chamber, or by varying the process components in the process chamber(s) of the processing system which offers a high flexibility and variability with respect to the process performable by the processing system as described herein.

After processing the substrate, the flexible substrate 10 is guided through the passageway 150, which may be arranged above the winding chamber, e.g. the second chamber 120, the maintenance zone 130, and the un-winding chamber, e.g. the first chamber 110. In some embodiments, the passageway 150 may be part of a top lid or may be provided as a tunnel below the maintenance zone and the first and second chambers. According to some embodiments, the tunnel may include one or more sluices, which may be able to separate the pressure conditions in the first process chamber 140A from the second process chamber 240 of the vacuum processing system 100. In some embodiments, gap sluices 180 are provided at each passage from one chamber to another chamber in the vacuum processing system 100, such as at the passage between the un-winding chamber to the first process chamber, between the first process chamber and the passageway, between the passageway and the second process chamber, and between the second process chamber and the winding chamber. In particular, the one or more gap sluices 180 may be configured as exemplarily described in detail with respect to FIG. 1C. After having passed the passageway 150, the flexible substrate 10 is guided (e.g. by one or more guide roller 104) to the second process chamber 240. According to some embodiments, the second process chamber 240 may be designed as the first process chamber 140A, or the process chamber described above with respect to FIGS, 1A to 1D. For instance, the second process chamber may include a process drum 142 and one or more processing components 141, such as deposition sources. In one example, the deposition sources of the second process chamber 240 may be arranged at the height of or below the center line or rotation axis 143 of the process drum 142. The substrate may be guided by the process drum 142 past the processing components 141. In the case that the processing components 141 in the second process chamber 240 are deposition sources, one or more additional layer(s) of deposited material may be coated on the substrate. According to some embodiments, the second process chamber provides an additional or complementary component for the layer deposited in the first process chamber on the substrate.

After processing the flexible substrate 10 in the second process chamber 240, the substrate may be guided to the second chamber 120 or winding chamber, where the processed substrate is wound on a take-up roll 121 for storing the processed substrate. It is to be understood that also in the exemplary embodiment as shown in FIG. 2, the first chamber 110 and/or the second chamber 120 may be accessed through the maintenance zone 130 for maintenance of the first and/or the second chamber, as described in detail above with respect to FIGS. 1C and 1D.

According to some embodiments, the wrapping angle of the deposition system having two process chambers may be less than 540°. As explained above, the rolls (including the guiding rollers, but not the supply roll and the take-up roll) in the deposition system having two process chambers according to embodiments described herein may be arranged so that the processed substrate surface is not touched by the rollers.

With exemplary reference to FIG. 2, according to some embodiments, the process chamber(s) of the vacuum processing system as described herein may be formed so as to provide a passageway for the substrate from the process chamber to an adjacent chamber, such as a winding chamber, or a further process chamber. For instance, the first process chambers 140A and/or the second process chamber 240 may provide a first arm-like extension 140E and/or a second arm-like extension 240E providing a passageway for the substrate in the vacuum processing system. According to some embodiments described herein, the passageway is thus provided by the process chamber(s) and the extension(s) thereof. In other embodiments, only one process chamber may be equipped with an extension for a passageway. According to some embodiments described herein, the passageway is thus provided above the first (vacuum) chamber and the second (vacuum) chamber.

It is to be understood that the processing system as described herein forms a common platform for a variety of processes and PVD processes, such as evaporation or sputtering, or CVD processes, such as a PECVD process or Tungsten (Wolfram) Chemical Vapor Deposition process (WCVD), which can be combined while the substrate is moved through the processing system. For example, the processing system as described herein may be employed for conducting a silane deposition process. It should be noted that different PECVD processes can be combined and, e.g., utilized for TFT or flexible TFT manufacturing, deposition of thin film barriers, more particularly for thin film ultra-high barriers.

Accordingly, the deposition system as described herein may therefore be offered with a modular mainframe design with the option "single drum (SD)" (embodiments described in FIGS. 1A to ID) and "double drum (DD)" (embodiment described in FIG. 2) for high flexibility. The modular design also offers flexibility in a number of sources. For instance, a plurality of bottom-up deposition sources may be offered, reducing the contamination risk. Deposition sources and even process chambers may be used or provided depending on process parameters, such as application type and layer stack.

In some embodiments, the design of the deposition system may be adapted for switching the second process chamber on and off depending on the respective application. For instance, the substrate having passed the first process chamber may be guided to the second process chamber or, optionally, to the winding chamber depending on the desired process. In one example, a control unit may activate respective guiding rollers for directing the substrate to the desired chamber. According to some embodiments, the alternative way of the substrate, such as the way to the second process chamber when the substrate is to be guided to the re-winding chamber directly after the first process, may be closed.

Accordingly, the systems described herein, having the flexibility and the space for various deposition sources, allow for a modular combination of several CVD, PECVD and/or PVD processes in a single deposition apparatus, e.g. a R2R coater. The modular concept, wherein all kinds of deposition sources including those which require very good gas separation can be used in a deposition system according to embodiments described herein, helps to bring down costs for the deposition of complex layer stacks that have to be deposited applying different deposition technologies or intricate combinations of process parameters.

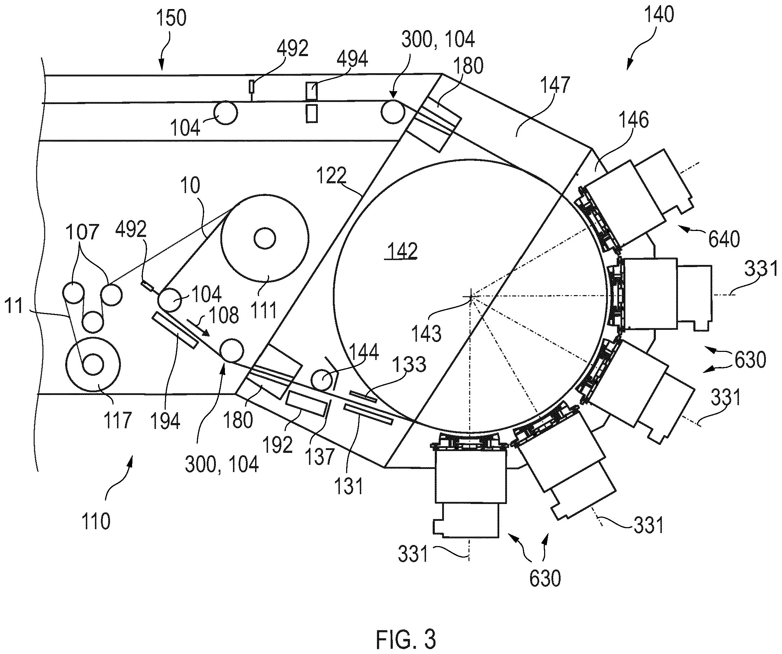

FIG. 3 shows a schematic sectional view of a part of the vacuum processing system as described herein. In particular, FIG. 3 shows an example of a configuration of the at least one process chamber e.g. process chamber 140 in FIG. 3, which may be connected to the first chamber 110 and the passageway 150 of the vacuum processing system according to embodiments described herein.

According to embodiments which can be combined with other embodiments described herein, the process chamber 140 may include a separation wall 122 which is inclined with respect to a vertical or horizontal orientation, as exemplarily shown in FIG. 3. For example, the angle of inclination of the separation wall 122 can be 20° to 70° relative to the vertical. Accordingly, the inclination of the wall allows for providing additional processing components, e.g. deposition sources, to be provided such that the axis of the additional processing component (see lines 331 shown in FIG. 3), e.g. the symmetry axis of a deposition source is at the same height or below the rotation axis 143 of the process drum 142. In FIG. 3, four deposition sources are shown which are provided, wherein one deposition source is arranged at the height of the rotation axis 143 of the process drum 142 and three further deposition sources are provided below the height of the rotation axis 143 of the process drum 142. As described above, with such a configuration flaking and falling of generated particles on the substrate can be reduced or avoided. The fifth processing station illustrated in FIG. 3 may for example be an etching station 640 which can, for example, be provided above the rotation axis 143 of the process drum 142. However, it is to be understood that one or more etching stations can also be provided at any of the other positions of the convex wall portion of the first part 146 of the process chamber 140. For example, the one or more etching station can be configured for plasma etching. Accordingly, embodiments as described herein may also be configured for R2R patterning, e.g. by applying one or more etching processes.

With exemplary reference to FIG. 3, according to some embodiments the substrate may be guided through a first vacuum processing region, e.g. of the lowest processing component in FIG. 3, and at least one second vacuum processing region, e.g. a further processing component on the right-hand side of the lowest processing component shown in FIG. 3. Even though it is often referred to herein to deposition sources being the processing components, also other processing components, like etch stations, heating stations, etc. can be provided along the curved surface of the process drum. Accordingly, the system described herein having compartments for various deposition sources allow for a modular combination of several CVD, PECVD and/or PVD processes, e.g. in a R2R coater configuration. Beneficially, the modular concept, wherein all kinds of deposition sources including those which require very good gas separation, can be used in the processing system according to embodiments described herein, helps to bring down costs for the deposition of complex layer stacks that have to be deposited applying different deposition technologies or intricate combinations of process parameters.

Accordingly, it is to be understood that according to embodiments described herein, the deposition sources, e.g. a plasma deposition source, can be adapted for depositing a thin film on a flexible substrate, e.g., a web or a foil, a glass substrate or silicon substrate. Particularly, the deposition source can be adapted for and can be used for depositing a thin film on a flexible substrate, e.g., to form a flexible TFT, a touch-screen device component, or other electronic or optical devices.

According to some embodiments, the distance of the curved outer surface of the process drum 142 and the flange or the convex shape of the chamber can be from 10 mm to 500 mm. In particular, the distance refers to the dimension from the process drum surface to the inner wall or flange portion, which delimits the vacuum area of the processing chamber 140. Providing the convex shape and the dimensions mentioned above allow for a reduced chamber volume in the first part 146 of the process chamber 140. The reduced chamber volume in the first part 146 of the process chamber allows for easier gas separation and easier evacuation of processing regions. For example, the second part 147 of the process chamber 140 may have a volume of the evacuatable region and the first part 146 of the process chamber 140 may have a further volume of the further evacuatable region, wherein the ratio of the volume to the further volume is at least 2:1, such as 3:1 to 6:1

According to yet further implementations, areas in the first part 146, which are not filled with a solid material, can be filled with blocks of materials to reduce the area to be evacuated. For example, the second part 147 has a volume of the evacuatable region and the first chamber portion 146 has a further volume of the further evacuatable region and the ratio of the volume to the further volume is increased by volume reduction blocks to at least 7:1.

With exemplary reference to FIG. 3, according to some embodiments, which can be combined with other embodiments described herein, an inspection system, particularly a layer measurement system (LMS), such as an optical measurement unit 494 for evaluating the result of the substrate processing can be provided. Accordingly, it is to be understood that embodiments as described herein provide a metrology capability, for example for the evaluation of layer thickness through the use of an optical reflection and/or transmission system, e.g. for use with transparent substrates.

Further, as exemplarily shown in FIG. 3, according to some embodiments at least one discharging assembly, e.g. discharging assembly 492 in FIG. 3, for adapting the charge on the substrate may be provided. For example, one discharging assembly 492 may be arranged in the first chamber 110 before the substrate is guided to the process chamber 140 and optionally a further discharging assembly 492 may be arranged at a position after the substrate has passed the process chamber, e.g. in the passageway 150. Providing a discharging assembly may be beneficial for improving the quality of the processing result since, for instance, positive and/or negative charges may accumulate on the substrate in the un-winding chamber. In particular, the charges may originate whilst the flexible substrate is unwound from the supply roll. The static charges may then remain on the substrate even when the web moves into the process chamber and, hence, may attract stray particles to the surfaces of the substrate. Thus, by providing a discharging assembly as described herein, ions of opposing polarity may be provided that move to the surfaces of the substrate to neutralize the charges. Accordingly, a clean and discharged surface of the flexible substrate can be provided to the processing regions such that the quality of the processing of the substrate, e.g. a coating, may be improved.

In the present disclosure, the term "discharging assembly" is intended to be representative of any device that is capable of ionizing a gas through an electric field. The discharging assembly may either be a passive or active unit or both. Further, the discharge assembly may include one or more neutralizing devices that may be connected to the power supply and control unit. The one or more neutralizing devices may be provided as a neutralizing lance or an ionization lance with one or more spikes. Further, a power supply, particularly a high voltage power supply, may be connected to the neutralizing device in order to provide high voltage to the one or more spikes to enable an electrical breakdown of a processing gas to produce ions that may move in the electric field towards the surfaces of the flexible substrate in order to neutralize the charges thereon. The control unit may initiate commands or execute pre-programmed discharging profiles such that a flow of negatively or positively charged ions is produced by the neutralization device that will flow to the surface of the substrate such that ions of opposite polarity to the charge on the surface of the substrate may move to the surface of the substrate and neutralize the charge there.

Accordingly, it is to be understood that according to embodiments described herein, the impact of particles on the production yield may be reduced by use of electrostatic charge mitigation devices, e.g. a discharging assembly as described herein, to prevent that particulate material from the un-winding chamber to the surface of the substrate may be attracted due to a charging of the substrate caused by the rolls employed for substrate transportation charge during unwinding. This helps to limit the level of extrinsic contamination at the substrate surface.

According to some embodiments, which can be combined with other embodiments described herein, the vacuum processing system 100 may include a pre-heating unit 194 to heat the flexible substrate 10 before processing, as exemplarily shown in FIG.3. For instance, the pre-heating unit 194 may be an electrical heating device, a radiation heater, an e-beam heater or any other element to heat the substrate prior to processing thereof. In particular, the pre-heating unit 194 may be configured to be a contactless heating device for the flexible substrate, i.e. the pre-heating unit may be able to heat the substrate to a defined temperature without making contact with the substrate. According to some embodiments, which can be combined with other embodiments described herein, the pre-heating unit 194 to heat the flexible substrate may be provided in the first chamber 110 as exemplarily shown in FIG. 3.

Further, additionally or alternatively a pre-treatment plasma source 192, e.g. an RF plasma source or ion source, can be provided to treat the substrate with a plasma prior to processing the substrate. For example, the pre-treatment plasma source 192 may be arranged in the process chamber 140, particularly in the second part 147 of the process chamber 140, such that the substrate may be pre-treated before entering the first part 146 of the process chamber 140. For example, the pre-treatment with a plasma can provide for a surface modification of the substrate surface to enhance film adhesion of a film deposited thereon or can improve the substrate morphology in another manner to improve processing thereof.

With exemplary reference to FIG. 3, according to embodiments which can be combined with other embodiments described herein, a heating device 131 may be provided which can spread the substrate. For example, the heating device 131 may be configured for spreading the flexible substrate 10 in a direction perpendicular to the substrate transport direction 108 or for maintaining a spread of the substrate in a direction perpendicular to the substrate transport direction 108. According to some implementations, the heating device 131 can be positioned opposing the front side of the flexible substrate 10. In particular, the heating device may be configured for providing a lateral stretch of the substrate without front surface contact and by providing heat to the flexible substrate. As shown in FIG. 3, according to some embodiments, optionally a heat adjustment unit 133 positioned opposing a first side of the heating device 131 may be provided. In particular, the heat adjustment unit 133 and the heating device 131 may be arranged to form a gap or a tunnel forming a path for the flexible substrate 10. For example, the heat adjustment unit 133 can be a further heating device, a heat reflector plate, or a combination thereof. The gap or tunnel formed by the arrangement of the heating device 131 and the heat adjustment unit 133 can have a dimension in a direction parallel to a substrate transport direction of at least 20 mm, for example 30 mm or longer. As exemplarily shown in FIG. 3, the heat adjustment unit 133 and/or the heating device 131 may be arranged adjacent to the process drum 142. For example, for a flat heating device surface opposing the substrate, the heating device surface can be essentially parallel to the substrate portion opposing the heating device surface, as exemplarily shown in FIG. 3. However, it is to be understood that the heating device surface may not necessarily be flat or parallel.

According to some embodiments which can be combined with other embodiments described herein, the heating device 131 can have a length along the transport direction of the substrate of at least 5 cm, typically of at least 10 cm, such as 20 cm to 80 cm. The width of the heating device can be at least 50% of the width of the substrate or at least 50% of the width of the process drum 142, i.e. the dimension in the direction of the rotation axis 143 thereof. According to an example, the width can be for example more than the width of the flexible substrate and/or the process drum, respectively, e.g. about 110% of the width of the flexible substrate.

According to an exemplary implementation of the heating device 131, the heating device 131 may be provided with two or more segments which can be individually controlled. Accordingly, the individual segments can be heated to a different temperature and/or the heat radiation emitted by each of the segments can be different. Particularly for embodiments having a heating device with a center segment and one or more outer segments, the heat radiation or heating of the center segment can be independently controlled from one or more outer segments. For example, the substrate can be heated more in the center of the substrate in order to generate a spread of the substrate by the increased temperature at the center portion thereof.

Further, particularly for thin substrates, for example a substrate having a thickness of 200 µm or below, or 100 µm or below, or 50 µm or below, for example about 25 µm, a wrinkle-free substrate processing and/or substrate winding is desired and challenging. Accordingly, the substrate spreading can be generated with a spreader roller and the spreading can be thermally supported without front surface contact. Accordingly, according to some embodiments, a wrinkle-free substrate winding and/or transport (or a substrate winding and/or transport with a reduced wrinkle generation) may be provided by a spreader roller 144, as exemplarily shown in FIG. 3.

In some configurations, the position of the spreader roller 144 without substrate front surface contact can result in a free-span length between the spreader roller 144 and the process drum 142 which may be too long for an effective spreader effect. Accordingly, beneficially the heating device 131 may "transport" that spreader effect of the spreader roller 144 to the process drum 142. In particular, the heating device may heat the substrate in a manner such that the substrate does not shrink to the initial length of the substrate on the path to the process drum. Additionally or alternatively, the heating device 131 may generate a further spread of the previously generated spread of the substrate. Accordingly, it is to be understood that the heating device can provide spreading without or in addition to a spreader roller. Optionally, further also the process drum 142 may be configured for being heated, e.g. the process drum may include heating elements.

For example, for reducing or even eliminating wrinkles in the substrate during substrate transport, the heating device 131 can be provided between the spreader roller 144 and the process drum 142. Accordingly, the heating device 131 may provide heat to the flexible substrate 10 in order to avoid that the spread introduced by the spreader roller 144 is lost, i.e. the spread substrate is heated by the heating device 131 such that the substrate does not shrink in the initial width of the substrate on the path from the spreader roller 144 to the process drum 142. Accordingly, the heating device 131 may reduce a de-spreading of the flexible substrate after the spreader roller 144 or may even increase the spread of the flexible substrate. According to some implementations, the distance of the heating device 131 to the process drum 142 may be 20 cm or below, particularly 10 cm or below. According to further embodiments, which can be combined with other embodiments described herein, the distance along a transport path of the flexible substrate from the spreader roller 144 to the process drum 142 can be 110 cm or below, particularly 50 cm or below.

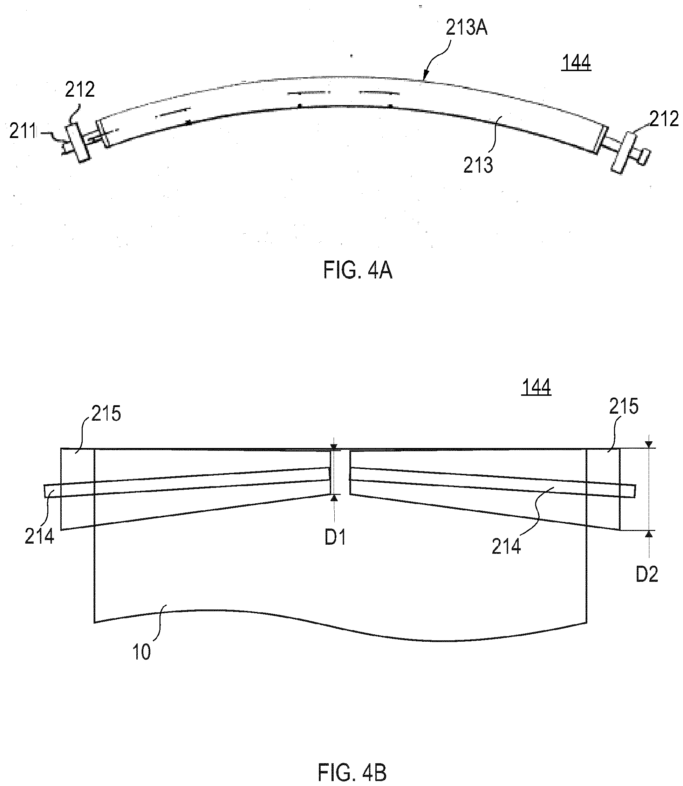

According to embodiments herein, the spreader roller 144 may be adapted for stretching the flexible substrate 10. In particular, the spreader roller may have a curved surface along the length direction of the roller. Accordingly, the curved surface of the spreader roller may have a tensioning effect in the width direction of the substrate, such that the flexible substrate 10 can be stretched along the substrate width. For example, the flexible substrate 10 can be stretched in a direction parallel to the rotation axis 143 of the process drum 142. It is to be understood that various types of spreader rollers can be provided, such as a bowed roller, a metal expandable roller, a curved bar roller, a grooved roller, or the like, some of which are explained in more detail with respect to FIGS. 4A and 4B. According to some implementations, the spreader roller may include an electrical heating for supporting or enhancing the mechanical stretch introduced by the spreader roller to the flexible substrate.

Exemplary embodiments of a spreader roller 144 are shown in FIGS. 4A and 4B. As exemplarily shown in FIG. 4A, the spreader roller 144 may include a bowed or curved center shaft (see e.g. center shaft 211 in FIG. 4A). The opposing ends of the center shaft can be supported by mounting supports. Further, a curved roll 213 may be provided on the center shaft 211. For example, the curved roll 213 can be provided by a flexible surface sheath which can, for example, be made of rubber or the like. Accordingly, the curved roll 213 may affect transverse expansion of the flexible substrate when the curved roll is disposed with the convex side 213A facing away from the flexible substrate.

Another example of a spreader roller 144 is shown in FIG. 4B. In this example, the spreader roller 144 may include two rotating elements 215, which rotate around respective axes 214. As exemplarily shown in FIG. 4B, the two axes may be inclined with respect to each other. The rotating elements 215 may have the form of a truncated cone, wherein the inner diameter D1 is smaller than the outer diameter D2. The upper side of the rotating elements in FIG. 4B, which is contacted by the flexible substrate 10, is arranged such that the two rotating elements are aligned essentially along a straight line. However, in a cross-sectional view in a direction perpendicular to the cross-sectional view shown in FIG. 4B, the flexible substrate 10 contacts the rotating elements 215 only at the outer portions of the flexible substrate 10. By guiding the flexible substrate 10 over the spreader roller 144, for example by rotating the two rotating elements, spreading of the flexible substrate can be achieved. The spreading can be increased by increasing the enlacement angle of the flexible substrate 10 around the spreader roller 144.

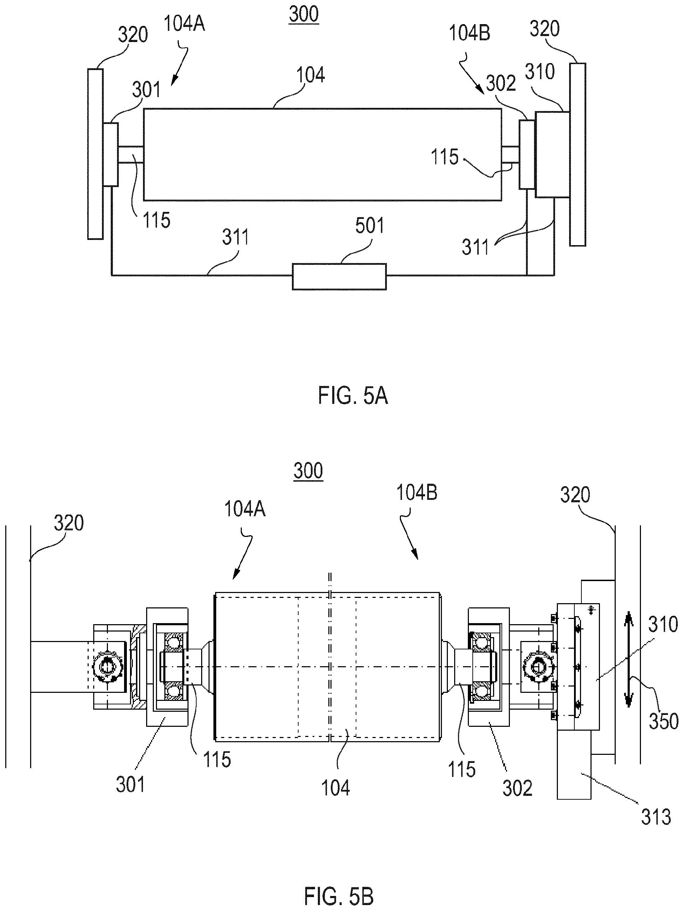

According to embodiments which can be combined with other embodiments described herein, the vacuum processing system may be provided with a substrate guide control unit 300 as exemplarily shown in FIG. 5A. The substrate guide control unit 300 may include a single guide roller, e.g. guide roller 104 in FIG. 5A. For example, the diameter of the guide roller 104 may be selected from the range between 65 mm and 300 mm. The guide roller 104 may, for example, be mounted to a shaft 115. As used herein, the term "shaft" shall include any support of the guide roller 104 that may be either rotatable (i.e., shaft in the strict sense), or may constitute a static axis about which the guide roller rotates. Notably, the single guide roller as described in combination with the substrate guide control unit is "single" in the sense that the substrate guide control unit provides the adjustment for substrate guiding without input from further data measured at other guide rollers of the substrate processing system. That is, the adjusting as described herein is based exclusively on the tension data measured at the single guide roller. The substrate guide control unit as described herein can operate without a second guide roller that is used to provide measurement data or to adjust the substrate.

According some embodiments, the guide roller 104 may be equipped with two substrate tension measurement units, e.g. a first substrate tension measurement unit 301 and a second substrate tension measurement unit 302 as exemplarily shown in FIGS. 5A and 5B. For example, the substrate tension measurement unit may include tension sensors such as a piezoresistive or piezoelectric tension sensor. Alternatively, the tension measurement unit may be equipped with a hall element or a capacitor in order to determine the tension. According to some embodiments, the substrate tension control unit is provided with even more than two substrate tension measurement units and thus, optionally, also with more than two sensors. According to some implementations, a substrate tension measurement unit as described herein may be adapted for measuring tensions of between 0 N/m and 1000 N/m.

According to some embodiments, the first substrate tension measurement unit 301 is at a first end of the guide roller 104, whereas the second substrate tension measurement unit 302 may be provided at a second opposite end of the guide roller 104. In this respect, it is to be understood that the term "end" of the roller is to be understood in the axial direction, i.e., as the position at or close to the end of the guide roller or the shaft of the guide roller. For the purpose of clarity, the first end 104A and the second end 104B are explicitly denoted by reference numbers in FIGS. 5A and 5B. Accordingly, the substrate tension measurement units may be positioned co-axially on the shaft 115 of the guide roller 104. Alternatively, the substrate tension measurement unit(s) may be embedded in the guide roller 104.

It is to be understood that the substrate tension measurement units as described herein are configured to measure the tension acting on the guide roller caused by the guided substrate. By measuring the tension on both sides of the guide roller and thus on both sides of the substrate, a difference in the tension can be measured. Based on the measured data, an appropriate adjustment can be undertaken.

According to some implementations, the substrate tension measurement units include a transducer and/or a strain gauge. In particular, the transducer may include a beam which stretches or compresses in response to varying tensions. The strain gauge measures the corresponding change in electrical resistance. The measurement performed by the strain gauge may be amplified and converted to a voltage or current for further processing.

For the purpose of illustration, in FIGS: 5A and 5B the guide roller 104 is shown as being mounted on a frame 320. The frame 320 may be any unit capable of supporting the substrate guide control unit 300. In particular, the substrate guide control unit may be provided with one or more bearings. For example, the bearings may be positioned between the substrate guide control unit 300 and the frame 320 in order to decouple a rotational movement of the shaft 115 from the frame. Notably, it is possible, but not necessary, that the frame 320 on both sides of the guide roller belongs to a one-piece frame.

With exemplarily reference to FIGS: 5A and 5B, the substrate guide control unit 300 may include an adjustment unit 310 for adjusting the alignment of the guide roller. The adjustment unit may be placed at the first end 104A or the second end 104B of the guide roller 104. For instance, as exemplarily illustrated in FIG. 5A, the adjustment unit 310 may be placed adjacent to the second substrate tension measurement unit 302. It is also possible that two adjustment units (not shown) are provided, for example, one adjustment unit 310 at each end of the guide roller 104.

In particular, the adjustment unit 310 may be applied for alignment of the guide roller 104 in order to avoid transversal tensions acting on the substrate. For example, the substrate guide control unit 300 may particularly be useful for compensating different coiling strengths at the guide roller 104, and consequently at all equipment subsequent to the guide roller 104. Different coiling strength can for example result in different thicknesses of the substrate along the width of the substrate. This may result in tilted feeding and, subsequently, varying contact between guiding rollers and the substrate to be guided which can go along with thermal complications.

Accordingly, it is to be understood that the tension data measured by the tension measurement units as described herein can be used for adjusting the alignment of the guide roller by moving one end of the guide roller. In that way, the alignment of the guide roller as compared to one or more of the horizontal and vertical direction can be adjusted. According to embodiments which can be combined with other embodiments described herein, the guide roller may be moved in a dimension that corresponds to the dimension in which the force caused by the substrate tension acts on the shaft of the guide roller. For illustration purposes, an exemplary movement of the guide roller 104 is indicated by the double-headed arrow 350 in Fig. 5B.

According to some embodiments as exemplarily shown in FIG. 5A, a controller 501 may be provided for controlling the substrate guide control unit 300. For example, the tension data on one end of the guide roller 104 as measured by the first substrate tension measurement unit 301 and the tension data on the opposite end of the guide roller 104 as measured by the second substrate tension measurement unit 302 may be supplied to the controller 501 via a data connection, such as a direct data line ("peer-to-peer") or a data bus. Alternatively, the data may also be supplied via wireless technology. In particular, the controller may be provided for undertaking one or more of the following tasks: receiving the measured tension data, evaluating the measured tension data, undertaking a calculation as to how the guide roller should be aligned, storing and retrieving data in and from a memory, controlling the adjustment unit, such as by controlling a motor for moving one end of the guide roller.

According to some embodiments that can be combined with other embodiments described herein, the controller 501 may be a separate device (as illustrated in FIG. 5A), e.g. including a CPU and possibly a data memory, in particular a personal computer. Alternatively, the controller may be integrated in one or both of the tension measurement units or the controller may be integrated in the adjustment unit. Alternatively, the controller may also be implemented in the main control of the vacuum processing system, e.g. by a respective program or software running in the main control.

Accordingly, it is to be understood that data connections 311 may be used to transmit information from the tension measurement units and/or the adjustment unit to the controller and/or to an external interface. For example, such an interface may include a personal computer which processes the data from the measurement units and/or the one or more adjustment unit. Also, the interface can include an analogue front panel including different elements to tune the adjustment unit 310, i.e. using different potentiometers, dials, switches, and displays. Further, the interface can also include a digital device including numeric pads, graphical display, text commands, or a graphical user interface. Typically, all these interfaces include different features such as controller function, calibration of the system, compensation of ambient conditions, or acquisition and recording of waveforms from the tension measurement units or the adjustment unit.

The data connections 311 are typically used to transmit the information from the measurement units, for instance via the controller 501, to the adjustment unit 310. The adjustment unit 310 receives information as to how the guide roller 104 should be adjusted. In the simplest implementation, the information may be limited to a signal as to whether an adjustment shall take place at all, and if so, in which direction. The adjustment unit may move the respective end of the guide roller into this direction until the signal changes to a "no-movement" signal or a signal indicating the adjustment unit to move the guide roller in the opposite direction again. However, the adjustment unit can be more sophisticated, e.g. the adjustment unit may receive information about the tension difference between the two sides of the guide roller, and the adjustment unit may initiate a respective movement of the guide roller until the tension is equalized.

According to some implementations, for connecting the data connection 311, different port types are used. For example, when serial communication is used, the ports are RS232, RS422, RS485, or universal serial bus (USB) ports. Particularly, parallel communication devices may be used when communication between the data connection 311 and a computer is desired. Most often used parallel communication devices are DB-25, Centronics 36, SPP, EPP or ECP parallel ports. The data connection 311 can be used to make the adjustment unit 310 compatible with transistor-transistor logic (TTL) or with programmable logic controllers (PLC). Additionally, the data connection 311 can be used to connect one or more of the tension measurement units and/or the adjustment unit with a network.

FIG. 5B shows a schematic cross-sectional view of another embodiment of the substrate guide control unit 300 of the present subject-matter. Throughout the whole disclosure herein, the same reference numbers are used for the same objects. The adjustment unit 310 is illustrated as including an adjustment actuator 313, such as a motor, for moving one end of the guide roller. Notably, this is not limited to the embodiment of FIG. 5B, and the one or more adjustment units of all embodiments described herein may be provided with an actuator, such as a motor. For instance, the motor may be a linear motor. As indicated by the double-headed arrow 350, the motor is capable of moving the end of the guide roller up and down in the shown perspective of this page.

According to some embodiments, the movement directions of the adjustment unit correspond to the measurement directions of the tension measurement units. That is, as in the illustration of FIG. 5B, the first substrate tension measurement unit 301 and the second substrate tension measurement unit 302 may be configured to measure the tension at the guide roller 104 in the same direction as the adjustment unit 310 is configured to move the guide roller 104. For instance, in the embodiment of FIG. 5B, the direction indicated by the double-headed arrow 350 may correspond both to the movement directions of the adjustment unit, and the measurement directions of the tension measurement units.

It is to be understood that various kinds of actuators can be used in the adjustment unit as described herein. For example, the actuator for adjustment can be an electrical or a hydraulic motor. Further, although not explicitly shown, rails or the like may be provided at the frame 320 along which the adjustment unit can move the respective ends (104A, 104B) of the guide roller 104.

Figure 6 shows a schematic sectional view of a part of the vacuum processing system as described herein. With exemplarily reference to FIG. 6, according to embodiments which can be combined with other embodiments described herein, the at least one process chamber, e.g. the first process chamber 140A and/or the second process chamber 240, may include a gas separation unit 370. As shown in FIG. 6, the flexible substrate 10 is guided via guide rollers (e.g. guide roller 104) and the process drum 142 through two or more processing regions, e.g. a first processing region 381 and a second processing region 382. In the exemplary embodiments of FIG. 6, five gas separation units 370 are shown. As can be seen from FIG. 6, according to some embodiments, two neighboring gas separation units may form a processing region there between. In other words, the individual processing regions may be separated by a gas separation unit. Accordingly, in FIG. 6 four processing regions can be identified. It is to be understood that the number of processing regions may be adapted according to a selected process to be conducted. According to embodiments, which can be combined with other embodiments described herein, each of the processing regions can be evacuated independently from each other according to the desired processing conditions. For example, as shown in FIG. 6, each of the processing regions may include a vacuum flange 402. Accordingly, the processing system may be configured such that one or more vacuum pumps or a vacuum pump arrangement can be connected to each of the respective vacuum flanges.

According to embodiments which can be combined with other embodiments described herein, an internal pump shielding may be utilized to control a gas flow within the process compartment, e.g. within the first processing region 381 and the second processing region 382. In particular, the internal pump shielding may include a shield geometry utilized to control fluid velocity streamlines. More particularly, the internal pump shielding may be configured to promote laminar gas flow such that recirculation/dead zones may be inhibited in order to reduce the risk of particulate nucleation and growth within the process compartment. Further, according to embodiments which can be combined with other embodiments described herein, the process compartment may be configured for a uniform pressure distribution within the process zone. In particular, the process compartment may be configured such that a minimal pressure difference in the direct vicinity of the gas injection nozzles can be obtained, e.g. less than 0.1% pressure difference within the deposition or coating zone.

According to some embodiments, the gas separation unit 370 may include a gas separation wall 372 which prevents gas in one processing region from entering a neighboring area, such as a neighboring processing region. Further, the gas separation unit 370 may be configured for adjusting a width of a slit 20 between the gas separation unit 370 and the process drum 142, as indicated by arrow 371. According to some embodiments, the gas separation unit 370 may include an actuator 374 which is configured to move an element 373 coupled to the actuator 374 as indicated by arrow 371. The element 373 of the gas separation unit 370 may provide the slit between the gas separation unit 370 and the flexible substrate 10 guided along the surface of the process drum 142. Accordingly, the element 373 may define the length of the slit and the position of the element 373 may define the width of the slit between the gas separation unit 370 and the flexible substrate 10. Accordingly, the gas separation unit 370 is adapted for separating neighboring vacuum processing regions and forming a slit through which the substrate can pass between the outer surface of the process drum and the gas separation unit. Further, the gas separation unit may be adapted to control fluid communication between neighboring processing regions, e.g. the first processing region 381 and the second processing region 382. It is to be understood that the first processing region 381 may be a first vacuum processing region and the second processing region 382 may be a second vacuum processing region. In particular, the fluid communication between neighboring processing regions may be controlled by adjusting the position of the gas separation unit, as indicated by arrow 371.

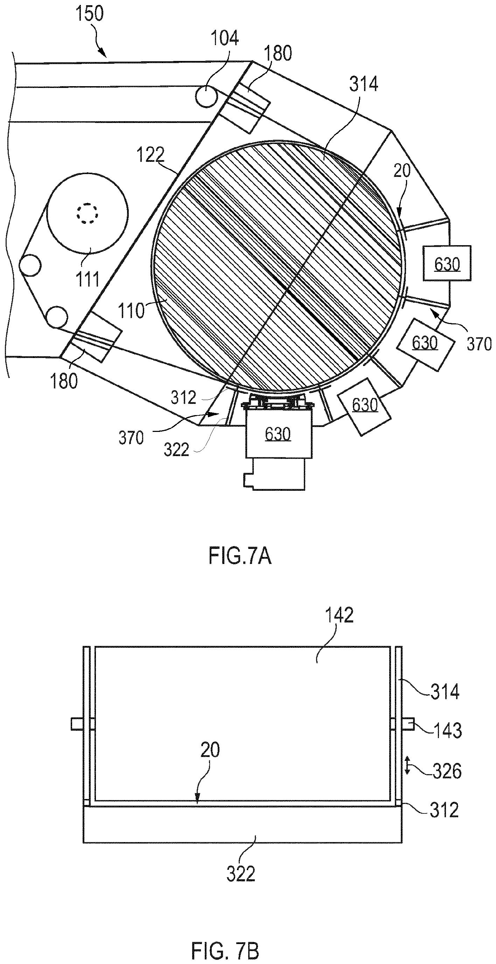

According to embodiments which can be combined with other embodiments described herein, the actuator 374 of a gas separation unit 370 can be selected from the group consisting of: an electrical motor, a pneumatic actuator such as a pneumatic cylinder, a linear drive, a hydraulic actuator such as an hydraulic cylinder, and a support, which has a predetermined thermal expansion coefficient when being exposed to predetermined heating or cooling, as described in more detail with respect to FIGS. 7A and 7B.

According to embodiments which can be combined with other embodiments describe herein, a slit width monitoring device 342, e.g. an optical measurement device such as a camera, may be provided as exemplarily shown in FIG. 6. The slit width monitoring device 342 may be used to measure the width of the slit 20 between the gas separation unit 370 and the flexible substrate 10. The slit width monitoring device 342 may be connected to a monitoring controller 450, e.g. by signal lines 343. The monitoring controller 450 may be connected with signal lines to the actuators 374 of the respective gas separation units. Accordingly, the monitoring controller 450 may initiate a signal for controlling the actuators 374 for adjusting the position of the gas separation units 370, particularly of the elements 373, as indicated by arrow 371.

With exemplary reference to FIG. 6, according to embodiments which can be combined with other embodiments described herein, the one or more deposition sources 630 may be provided with connections 631. The connections 631 can be electrical connections and/or connections for input and output of processing gas. Further, one or more monitoring devices 633 can be provided for the deposition sources 630. For example, the monitoring device 633 can be a device for measuring the electrode voltage and/or electrode current and/or a plasma impedance at the deposition source, e.g. after the match circuit. Additionally or alternatively, also the gas flow into the processing region of the deposition source and out of the processing region of the deposition source can be monitored. For example, the pressures at the respective conduits and/or even the gas mixture could be analyzed. It is to be understood that if the width of the slit 20 increases, the gas separation factor decreases and process gases of adjacent processing regions can enter. Accordingly, embodiments as described herein may be configured for changing the gas pressure and the gas mixture such that the plasma conditions in the processing regions may vary. Accordingly, the monitoring device 633 can be utilized for determining the plasma conditions. In light of the fact that the plasma conditions vary, e.g. if the diameter of the process drum increases, for example, due to thermal expansion, the monitoring device 633 can be utilized for determining the slit width between the source and the process drum. For example, one or more signals relating to the slit width and/or the plasma condition can be provided to the monitoring controller 450, e.g. by signal lines 343. Since the monitoring controller 450 may be connected to the actuators 374, as outlined above, the slit width of the gas separation units can be adjusted accordingly. Accordingly, it is to be understood that the monitoring controller 450 may be employed for controlling the adjustment of the slit width. In particular, the adjustment of the slit width can be automated. Accordingly, an improved or optimized gas separation factor can be provided throughout operation of the vacuum processing system as described herein. This can also prevent the risk of scratching the process drum when the temperature of the process drum is increased.

According to some embodiments, which can be combined with other embodiments described herein, the monitoring device can be a CVD process monitor. For example, the monitoring device can measure at least one of the group consisting of: the voltage, the current, the phase, the harmonics, the impedance or, by using an algorithm, the plasma density, of the deposition source. Corresponding plasma monitoring devices can be used for endpoint detection of cleaning processes, notification of silane dust formation, and for real-time non-invasive process feedback, e.g. in the form of plasma density for system controlled algorithms. However, according to some embodiments described herein, additionally the monitoring device can be utilized for determining the distance of an electrode of the PECVD source from the substrate and/or the corresponding counter electrode provided behind the substrate, for example the process drum. Additionally or alternatively, also process gas variations due to a varying slit width of the gas separation unit can be measured with the monitoring device.

Accordingly, it is to be understood that according to some embodiments, a non-invasive plasma characterization method can be provided by the monitoring device, e.g. an impedance sensor. For example, the impedance sensor can be used either as a pre-match or a post-match sensor, i.e. for the match circuit or after the match circuit. Accordingly, a post-match mounting of the monitoring device may provide direct information on RF voltages on the electrodes and the actual plasma impedance. According to some embodiments, an electronic "fingerprint" of the plasma can be provided, wherein also the distance of the electrode from the substrate or process gas contamination from adjacent regions can be determined. The differences in phase angle and/or harmonic signal amplitude can show subtle changes in process conditions, for example onset of process drifts. Accordingly, indirect information on ion flux incident at powered electrode surfaces and, hence, plasma density can be provided, particularly by measurement of the harmonics in the system of powering the deposition source.

According to some embodiments which can be combined with other embodiments described herein, the deposition sources, e.g. plasma enhanced deposition sources, can be operated at a frequency of 2 MHz to 90 MHz, for example a frequency of 40.68 MHz, and the monitoring device, e.g. an integrated impedance sensor, can provide for real time in-line process monitoring and control of respective process parameters, for example, the width of the slit of the gas separation unit and/or the distance of the electrode of the deposition source from the substrate.

In light of the above, it is to be understood that, according to some embodiments described herein, the slit width of the gas separation unit can be adjusted while the vacuum processing system is in operation. Accordingly, variations in the slit width, for example, due to thermal expansion of the substrate support, e.g. the process drum, can be compensated for and the slit width of the gas separation unit can be adjusted to individual operation conditions. This can be particularly useful in applications for which a high gas separation is required, e.g. PECVD processes. Accordingly, the vacuum processing system as described herein having compartments for various deposition sources allow for a modular combination of several CVD, PECVD and/or PVD. Such a modular concept, wherein all kinds of deposition sources including those which demand very good gas separation can be used, helps to bring down costs for the deposition of complex layer stacks that have to be deposited applying different deposition technologies or intricate combinations of process parameters.

Further, it should be noted that embodiments as described herein can be beneficial with respect to the following aspects: many process runs need low process drum temperatures, around 0°C. At low temperatures a fixed slit width, which has been adjusted for higher process drum temperatures, is in the order of 1.5 to 2.0 mm if thin plastic film (e.g. 50 microns) is used. In this case the gas separation factor is often below the specified gas separation factor (1:100). This is critical for process runs in which layer materials are deposited with different reactive gas compositions in neighboring processing regions, e.g. sputter chambers. Where such conditions might apply is, for example, during deposition of Nb2O5 and ITO. This can be the case, for example, for touch panel manufacturing. Accordingly, embodiments of the vacuum processing system described herein are particularly useful for manufacturing multilayer applications, e.g. in display devices such as touch panels.

As mentioned above, embodiments refer to an adjustment of the gas separation unit during machine operation, particularly an automated adjustment or a "self" adjustable gas separation wall. This can apply for sputter deposition but also to CVD and PECVD deposition, and particularly applies for deposition wherein a processing gas includes a reactive gas component, wherein the reactive gas component is partly or fully incorporated in the layer to be deposited. Similar to sputter web coaters (R2R coaters), the gas separation is beneficial for layers deposited in a reactive atmosphere. By using a self-adjustable or automatically adjustable gas separation unit, the slit width can be changed according to different thickness values of the substrate. It is to be understood that an improved gas separation factor can also have an impact on the design of the vacuum processing system. In particular, the length of the gas separating units between two compartments can be reduced, i.e. the length of the slit 20 and/or of the element 373 shown e.g. in FIG. 6 can be reduced. This has an impact which may result in a reduction of size, costs and footprint of the vacuum processing system.

According to some embodiments, which can be combined with other embodiments described herein, the width of the slit 20 between the gas separation unit 370 and the flexible substrate 10, which is defined by the element 373 of the gas separation unit 370, can be adjusted by a support arrangement, e.g. including a disc 314, as exemplarily shown in FIGS. 7A and 7B. For example, the disc 314 may have essentially the same diameter as the process drum 142. Even though the process drum 142 is drawn to be slightly larger than the disc 314 in FIG. 7A, this is mainly for illustrating purposes as the process drum 142 and the disc can have the same diameter. The disc 314 may be mounted to the rotation axis 143. According to some embodiments, the disc 314 remains stationary during rotation of the process drum 142, i.e. the disc does not rotate together with the process drum.

In the example of the gas separation unit 370 as exemplarily shown in FIGS. 7A and 7B, a wall element 322 is connected to the disc 314 by a connection element 312. Accordingly, according to some embodiments, the connection element 312 may determine the width of the slit 20. According to alternative embodiments, which can be combined with other embodiments described herein, the disc 314, the connection element 312 and the wall element 322 can also be provided as one integral unit, or the disc 314 and the connection element 312, or the wall element 322 and the connection element 312 can be provided as one integrally formed unit.

It is to be understood that if the temperature of the process drum 142 varies, the diameter of the process drum 142 may vary. Accordingly, the width of the slit 20 may be affected by the variation of the diameter of the process drum and, according to some embodiments described herein, an adjustment of the width of the slit can be provided. The support arrangement of the gas separation unit 370 including the disc 314 and the connection element 312, provides for an adjustment of the width of the slit 20 as indicated by arrow 326 in FIG. 7B. According to some embodiments, the disc 314 can be passively heated or passively cooled by the process drum 142. Accordingly, the disc 314 can be provided at a temperature which is essentially the same as the temperature of the process drum 142 for example, the temperature of the disc 314 can vary from the temperature of the process drum 142 by +- 10°C. Accordingly, the disc 314 also experiences the thermal expansion such that thermal expansion of the process drum 142 is followed by the thermal expansion of the disc 314.

According to yet further embodiments, which can be combined with other embodiments described herein, additionally or alternatively, the disc 314 or a similar support for the gas separation unit 370 can be provided with cooling channels or heating elements. Accordingly, the temperature of the disc 314 can be individually controlled. Hence, the thermal expansion of the disc 314 can be controlled independently of the temperature of the process drum 142 such that the width of the slit 20 can be adjusted.

With respect to the influence of the temperature on the process drum and the disc, the following aspects are to be noted. In the following example, the process drum may be made of stainless steel and the disc may be made of aluminum. Accordingly, with a thermal expansion coefficient of stainless steel αss = 0,000016 K-1 and of aluminum αAl = 0.0000238 K-1, αdrum / αdisk = 0.6723 can be obtained. Thus, for example, a disk temperature of 268.91°C can be provided to correspond to a drum temperature of 400°C. Accordingly, the thermal expansion of the process drum at 400°C may be compensated for. In the case that the disc 314 is made of a material which has the same thermal expansion coefficient as the process drum 142 or consists of the same material as the process drum 142, and if the temperature of the disc 314 can be controlled to be essentially the same as the temperature of the process drum 142, then the thermal expansion (see, for example, arrow 326) is essentially the same. Thus, the width of the slit 20 varies only by the thermal expansion of the connection element 312. In this regard, it should be noted that the length of the connection element 312 is shorter as compared to the radius of the process drum 142. Accordingly, the variation of the slit widths to thermal expansion is significantly reduced. Further, it is possible to select the material of the connection element 312 with a low thermal expansion coefficient, such that the influence of the temperature on thermal expansion of the connection element 312 can be further reduced.

According to embodiments which can be combined with other embodiments described herein, the material of the disc 314 can be selected to be different from the material of the process drum 142 and can be selected to have a different thermal expansion coefficient as compared to the process drum. Accordingly, the thermal expansion of the disc 314, which corresponds to the thermal expansion of the process drum 142, can be provided by different temperatures, such that there is no necessity to provide the same temperature at the disc 314 as compared to the process drum 142. In particular, if the disc 314 and the connection element 312 are integrally formed, a different thermal expansion coefficient can also compensate for the larger radial dimension of the disc 314 in combination with the connection element 312

Although FIGS. 7A and 7B refer to a disc which is circular similar to the process drum 142, according to other embodiments the support arrangement for supporting the gas separation unit 370 can also be a portion of a disc, a rod, or any another suitable shape. Further, it should be noted that even though the above described aspects and details refer to thermal expansion, a shrinkage can also be provided during operation, for example, if after a first process at higher temperatures, the process drum is cooled to lower temperatures. Accordingly, it is understood that the term "expansion" refers to the behavior resulting from the thermal expansion coefficient of an element, i.e. the thermal expansion can have a positive or a negative sign.

In view of the above, it is to be understood that, according to some embodiments described herein, a gap adjustment device (e.g. by means of a support arrangement including a disc or by means of an actuator configured as described herein) for the gas separation unit can be provided. In particular, the gap adjustment device may be configured for adjusting a width of a slit between the process drum and the gas separation unit and/or the deposition source body. Accordingly, the gap adjustment device ensures for constant and high level of gas. Further, it is to be understood that embodiments of the gas separation unit as described herein may be configured for providing a uniform thermal expansion, e.g. by co-heating or co-cooling the gas separation unit by thermo-oil circuit, during a heating or cooling phase. In particular, embodiments of the gas separation unit as described herein may be configured for providing a temperature uniformity of less than ± 2.5% non-uniformity.

Figure 8 shows a schematic cross-sectional view of a deposition source 630 which may be employed as a process component for the vacuum processing system as described herein. According to embodiments which can be combined with other embodiments described herein, the deposition source 630 includes a main body 603 and an electrode 602 which may be supported by the main body. For example, the deposition source 630 may be a plasma deposition source. The electrode 602 may be connected to a match circuit 680 for providing power to the electrode such that a plasma in the processing region of the deposition source 630 may be generated. Accordingly, the deposition source 630 may be configured for generating a plasma between the electrode 602 and the flexible substrate 10 to be processed during operation. Accordingly, the deposition source can be configured such that plasma in the processing region can be ignited and maintained.

According to embodiments which can be combined with other embodiments described herein, the deposition source 630 may further include a processing gas inlet 612 for providing a processing gas mixture into the processing region and a processing gas outlet 614, e.g. an evacuation outlet, for removing the processing gas mixture from the processing region. In particular, a plurality of openings or a slit opening can be provided as gas inlet and/or gas outlet, respectively. Accordingly, the processing gas may flow from processing gas inlet 612 to processing gas outlet 614. According to embodiments, the processing gas inlet and processing gas outlet can extend in the direction perpendicular to the paper plane of FIG. 8. Particularly, the processing gas inlet and the processing gas outlet may be provided to extend at least along the width of the substrate to be processed and/or at least along the desired length of the processing region. Beneficially, the processing gas inlet and the processing gas outlet may be configured to extend at least slightly beyond the maximum substrate width in order to provide uniform conditions in the area of the substrate to be coated.

According to some embodiments, which can be combined with other embodiments described herein, the deposition source 630 and the gas separation units 370 can be formed as one arrangement. For example, FIG. 8 shows the gas separation unit 370 mounted to the main body 603 of the deposition source 630. Accordingly, an adjustment of the slit width of the gas separation unit and an adjustment of the distance between the electrode 602 and the substrate can be provided in a combined manner.

With exemplary reference to FIG. 8, the deposition source 630 can be connected to a wall 102 such that the distance of the main body 603 and the wall 102 can vary (indicated by bellows 632 in FIG. 8). As shown in FIG. 8, the main body 603, the electrode 602, and/or the gas separation unit 370 can be supported with a support being in mechanical contact with the axis of the process drum. Accordingly, it is to be understood that the slit width of the gas separation unit as well as the distance between the electrode 602 and the substrate can be adjusted as exemplarily described above with respect to FIGS. 7A and 7B. Alternatively, an actuator can be provided between the main body 603 of the deposition source 630 and the wall 102 such that the position of the main body, the gas separation unit and the electrode can be varied for adjustment of the distance to the substrate.

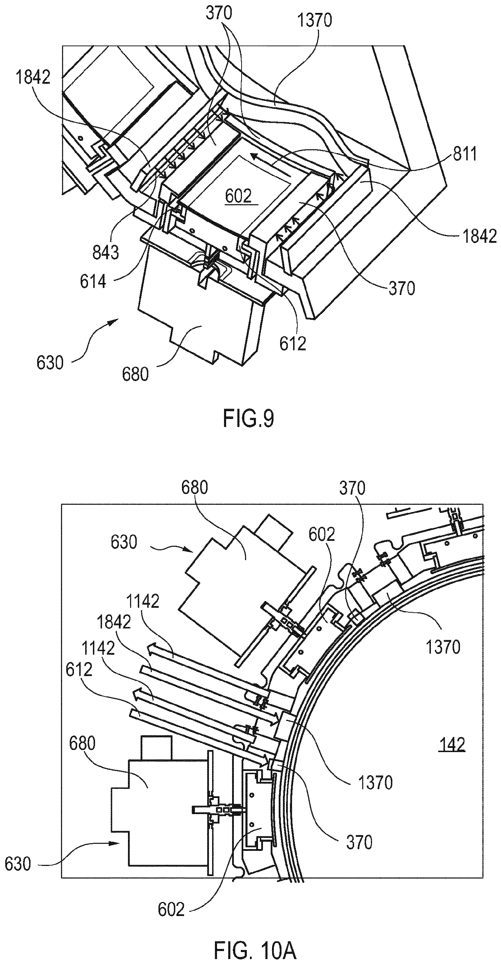

FIG. 9 shows a schematic perspective sectional view of a deposition source 630 mounted to a wall of the process chamber according to embodiments described herein. As exemplarily shown in FIG. 9, according to embodiments which can be combined with other embodiments described herein, one or more gas separation units 370 can be provided around the processing region provided between the electrode 602 and the substrate to be processed. In particular, the perspective sectional view of FIG. 9 shows gas separation units 370 which are arranged at three sides of the electrode 602. Further, in FIG. 9 the processing gas flow in the processing region is shown. In particular, as indicated by arrow 811, the processing gas flows from the processing gas inlet 612 to the processing gas outlet 614.

Further, as shown in FIG. 9, according some embodiments one or more separation gas inlets 1842 can be provided e.g. two separation gas inlets as shown in FIG. 9. Accordingly, a separation gas or purge gas may be provided in the intermediate areas between the separation gas inlets 1842 and the gas separation unit 370 as indicated by arrows 843. Additionally, according to some embodiments, a further gas separation unit 1370 may be provided to provide a gas flow barrier. Accordingly, a corresponding pressure as described above can be provided in these areas. Even though not shown in FIG. 8, a separation gas or purge gas as indicated by arrows 843 can also be provided in an opposing direction for providing purge gas for a neighboring plasma deposition source.

FIGS. 10A to 10C show different embodiments of the flow of processing gas, the flow of purge gas or separation gas, and suction or pumping regions according to embodiments described herein. FIG. 10A shows two deposition sources provided adjacent to each other at respective processing regions (see, e.g., deposition source 630 in FIG. 10A). The processing regions are provided at the process drum 142 which forms a curved substrate support surface. As exemplarily shown in FIG. 10A, each of the deposition sources may have an electrode 602. At one side of the electrode 602, a processing gas inlet 612 is provided. For example, the gas inlet can be a slit or a plurality of openings extending in an axial direction of the process drum 142. Adjacent to the processing gas inlet 612, a wall portion forming the gas separation unit 370 is provided. The deposition source 630 shown in FIG. 10A includes a match circuit 680, which is connectable to the electrode 602 such that the power for igniting and maintaining a plasma in the processing region can be provided to the electrode. Further, as shown in FIG. 10A, according to embodiments which can be combined with other embodiments described herein, between the deposition sources or the respective processing regions a separation gas inlet 1842 for a separation gas, such as hydrogen, can be provided. Further, pumping or suction channels may be provided between the deposition sources or the respective processing regions. Additionally, vacuum channels 1142, e.g., pumping ports may be positioned on both sides of the separation gas inlet 1842, as exemplarily shown in FIG. 10A.

According to some embodiments, which can be combined with other embodiments described herein, the separation gas inlet 1842 can further include a wall portion providing a further gas separation unit 1370. According to embodiments, which can be combined with other embodiments described herein, the at least one of the deposition source 630 may include an actuator to vary the distance of the deposition source from the process drum 142. Accordingly, a variation of the distance can be provided by an actuator, as for example described with respect to FIG. 6, or can be provided by the support arrangement as described with respect to FIGS. 7A and 7B. Thus, the radial position with respect to the axis of the process drum 142, the electrode 602, the first gas separation unit, e.g. gas separation unit 370 in FIGS 6-8, and the further gas separation unit 1370 can be varied and adjusted. For example, the variation and adjustment can be utilized for compensating thermal expansion or shrinkage of the process drum upon temperature variations of the process drum, as exemplarily described with respect to FIGS. 6, 7A and 7B.

With exemplary reference to FIG. 10A, according to embodiments which can be combined with other embodiment described herein, the separation gas inlet 1842 may be provided between the deposition sources 630 and a vacuum channel 1142, e.g. an evacuation duct provided on both sides of the separation gas inlet 1842. From FIG. 10A, it is to be understood that the process drum extends in a direction perpendicular to the paper plane of figure 10A. Further, the electrodes, the gas inlets, the gas outlets and evacuation ducts extend in the direction perpendicular to the paper plane in FIG. 10A.

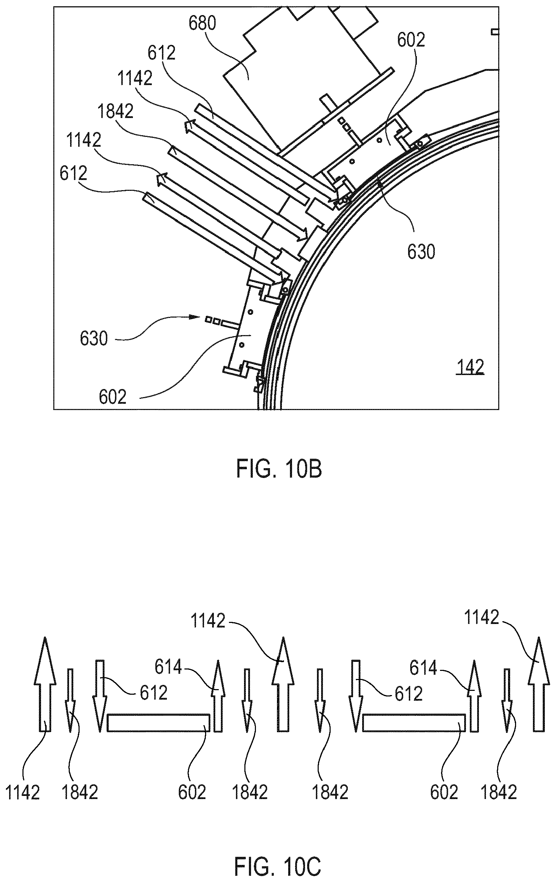

FIG. 10B shows an exemplary embodiment, in which contrary to the embodiment shown in FIG. 10A, a processing gas inlet 612 is provided for both deposition sources 630 between the respective deposition sources, such that the process gas flow direction is provided in the same direction as the substrate transport direction for one of the deposition sources and in the opposite direction for the respective other one of the deposition sources.

FIG. 10C illustrates the schematic concept of various gas inlets and evacuation or suction channels for adjacent deposition sources. In particular, FIG. 10C illustrates the gas inlets, the gas outlets, and the evacuation ducts in the form of arrows. It is to be understood that the respective channels and ducts can be provided according to any of the embodiments described herein. FIG. 10C shows two neighboring electrodes, which are considered as a portion of a deposition source at the respective position. According to embodiments, which can be combined with other embodiments described herein, the electrodes 602 can be electrodes for a plasma assisted deposition process, such as the electrodes of a PECVD source. As shown in FIG. 10C, the processing gas inlet 612 and the processing gas outlet 614 may be provided at the opposing sides of the electrode 602 for each of the neighboring deposition sources. Further, a separation gas inlet 1842 can be provided at both sides of the electrode 602, such that the processing gas inlet 612 and the processing gas outlet 614, respectively, are positioned between the electrode 602 and the respective separation gas inlet (see e.g. separation gas inlet 1842). Further, as exemplary shown in FIG. 10C, vacuum channels 1142, i.e. suction channels or evacuation ducts can be provided. In particular, the evacuation ducts may be provided at the respective opposing sides of the electrode 602 such that the separation gas inlet 1842 and the processing gas inlet 612 and the processing gas outlet 614 are provided between the evacuation ducts and the electrode 602.

Embodiments described herein are particularly useful for applications where different processes are provided in adjacent or neighboring processing regions. For example, the deposition source illustrated by electrode 602 on the left side in FIG. 10C can conduct a first deposition process, wherein the deposition source illustrated by the electrode 602 on the right side of FIG. 10C can conduct a second, different deposition process. If for example the pressure in the left processing region is 0.3 mbar and the pressure in the right processing region is 1.7 mbar, the pressure in the region of the middle vacuum channel can for example be provided to be below the lower pressure of the two processing areas. In the above example, the pressure can be 0.2 mbar. According to further embodiments, which can be combined with other embodiments described herein, in the event that more than two deposition sources are provided, the pressure in the regions of the evacuation ducts may be provided to be lower than the smallest pressure in any of the processing regions.

According to further embodiments, which can be combined with other embodiments described herein, wall portions or elements of gas separation units can be provided for the arrangement described with respect to FIG. 10C. Accordingly, wall portions or elements of gas separation units can be provided between the process gas inlets and the separation gas inlets as well as the process gas outlets and the separation gas inlets, and can further be provided between the separation gas inlets and the evacuation ducts, as exemplarily described with respect to FIGS. 8, 9 and 11.

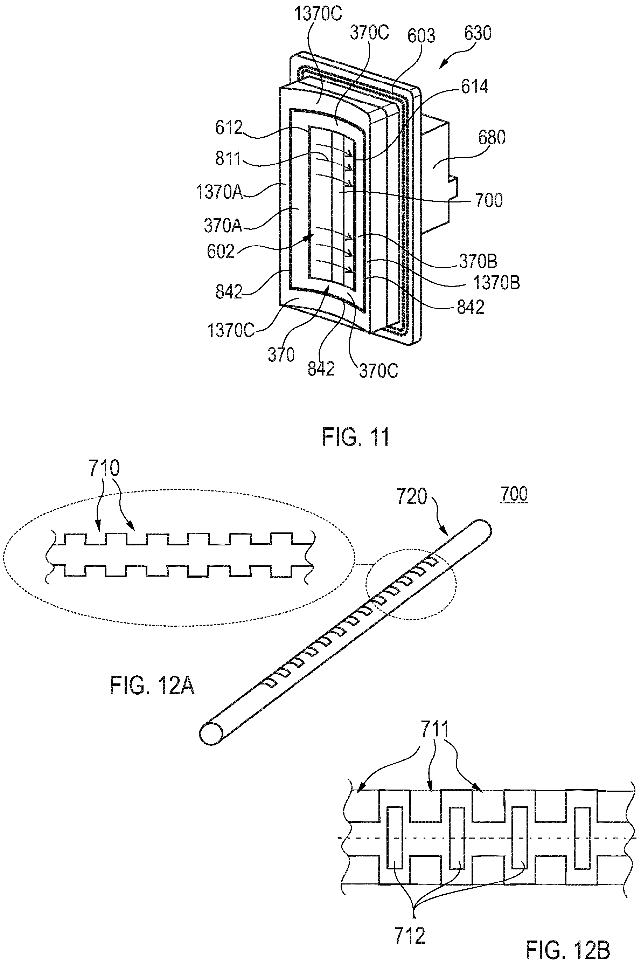

FIG. 11 shows a schematic perspective view of a deposition source according to embodiments described herein. As described above, the deposition source 630 includes an electrode 602 which can be connected to a match circuit 680 such that the electrode 602 is powered. As shown in FIG. 11, the electrode 602 can be provided with a curved surface, such that the electrode corresponds to the process drum, i.e. the electrode has an essentially parallel surface with respect to the surface of the process drum. Arrows 811 schematically show a gas flow of processing gas in the processing region along the electrode 602. Respective slits of the process gas inlet 612 and the process gas outlet 614 are highlighted by the bold lines in FIG. 11. Accordingly, according to some implementations, particularly for PECVD processes, the process gas flow can be asymmetric, i.e. either in the direction of the substrate movement or opposite the direction of the substrate movement.

As exemplarily shown in FIG. 11, according to embodiments which can be combined with other embodiments described herein, the gas separation unit 370 may be provided around the electrode 602. Accordingly, the gas separation unit 370 may include a first gas separation unit portion 370A on one side of the electrode 602 and a second gas separation unit portion 370B on an opposing side of the electrode 602. Further side portions 370C of the gas separation unit 370 can be provided. Accordingly, the gas separation unit 370 surrounding the electrode 602 may provide for an improved separation factor.

Further, according to some embodiments which can be combined with other embodiments described herein, one or more openings of a separation gas inlet 1842 can be provided at the first side of the electrode 602 and an opposing side of the electrode 602. The one or more openings of the separation gas inlet 1842 may also be referred to as one or more separation gas inlet openings. As exemplarily shown in FIG. 11, according to some implementations the separation gas inlet 1842 may be configured to surround the electrode 602 such that the gas separation unit 370 is arranged between the separation gas inlet 1842 and the electrode 602.

According some embodiments, which can be combined with other embodiments described herein, a further gas separation unit 1370 can be provided. For example, the further gas separation unit 1370 may include a first further gas separation portion 1370A and a second gas separation portion 1370B provided at the opposing sides of the electrode 602. Alternatively, two gas separation units can be provided instead of the first and second portions of the further gas separation unit 1370 shown in FIG. 11. For example, the further gas separation unit 1370 shown in FIG. 11 includes further side portions 1370C such that the further gas separation unit 1370 surrounds the electrode 602, the first gas separation unit, e.g. gas separation unit 370 in FIG. 11, and the separation gas inlet 1842.

In view of the above, it is to be understood that embodiments described herein may provide for an increased and optimized separation factor between adjacent processing regions.

As exemplarily shown in FIG. 11, according to embodiments which can be combined with other embodiments described herein, the deposition source 630, e.g. a PECVD deposition source may include a microwave antenna 700. Accordingly, it is to be understood that a deposition source as described herein may be a microwave source and be configured to provide microwave plasma. A detailed view of an exemplary embodiment of a microwave antenna 700 is shown in FIG. 12. According to some embodiments, the microwave antenna 700 may be in the form of an elongated sleeve 720 and include a plurality of slots 710, which are provided along the length of the microwave antenna 700. In particular, the plurality of slots 710 may be evenly distributed over a portion of the length of the microwave antenna, as exemplarily shown in FIG. 12A. Accordingly, the slotted antenna may be configured for controlled power delivery to plasma in the processing region. Further, the slot opening in the sleeve 720 of the microwave antenna 700 can ensure that the sleeve which may, for example, be made of metal is to be semitransparent for the microwaves.

According to some embodiments which can combined with other embodiments described herein, the microwave antenna 700 may be provided with a first group 711 of slots and a second group 712 of slots, wherein the first group of slots is arranged on a different radial position along the length of the antenna compared to the second group of slots, as exemplarily shown in the enlarged sectional view of the microwave antenna in FIG. 12B. This may be beneficial in order to improve the power coupling efficiency.

In view of the above, it is to be understood that the arrangement of the slots may provide for the ability to control axial power absorption along the length of the antenna. In particular, the spacing and/or the shape of the slots may provide for fine control of the power absorption profile. Accordingly, a slotted antenna for controlled microwave power delivery may be provided.

According to embodiments which can be combined with other embodiments described herein, the deposition source may be a linear microwave PECVD source. For example, the deposition source may be attached to a rail mounted process trolley. Further, the deposition source may include at least one of a geometrically floating plasma source to ensure gap distance, a fully integrated source gas separation, an optional multipole resonance sensor for online plasma density monitoring, a specially designed process gas manifold for high layer uniformity, low maintenance and ease of cleaning. For example, the process gas manifold may be replaceable. Further, according to some embodiments, the deposition source, e.g. the linear microwave PECVD source, may be configured to be compatible with liquid precursors. According to further embodiments which can be combined with other embodiments described herein, the deposition source may include a fluorine based in-situ plasma clean capability. Moreover, it should be noted that the deposition source, particularly a linear microwave PECVD source, may be configured for excellent plasma confinement for dust minimization during processing.

Further, it is to be understood that embodiments of the deposition source as described herein have a robust and optimized design. In particular, the robust and optimized design of the deposition source can be obtained by providing a one or more of a replaceable gas manifold, an optional coaxial line gas cooling system, an adaptable internal source pump shielding and an exchangeable lower source housing unit, e.g. including a gas separation usable for coating width modification.

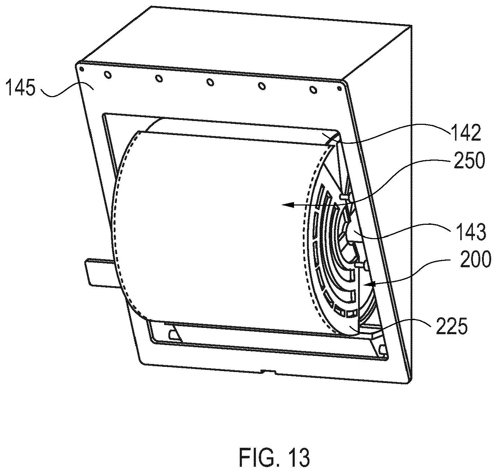

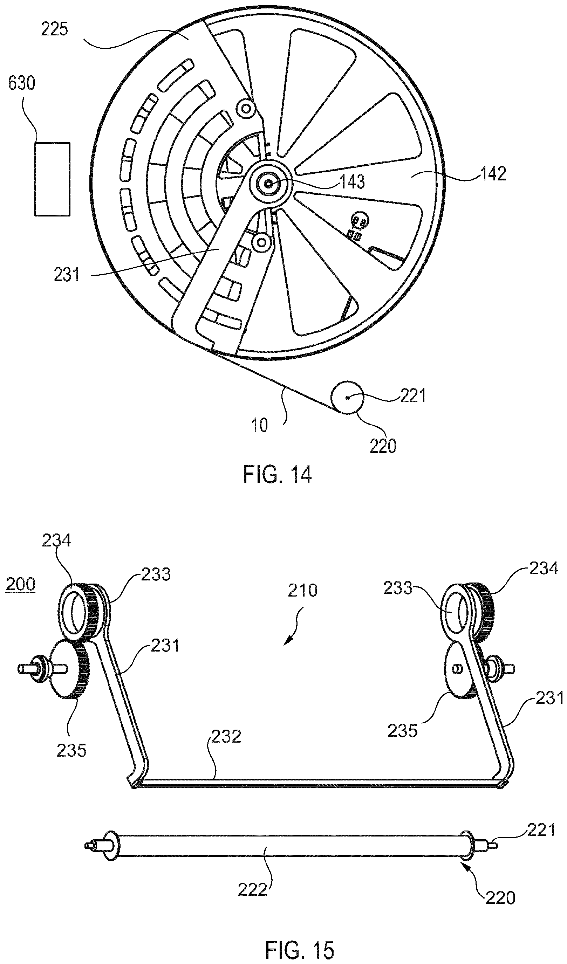

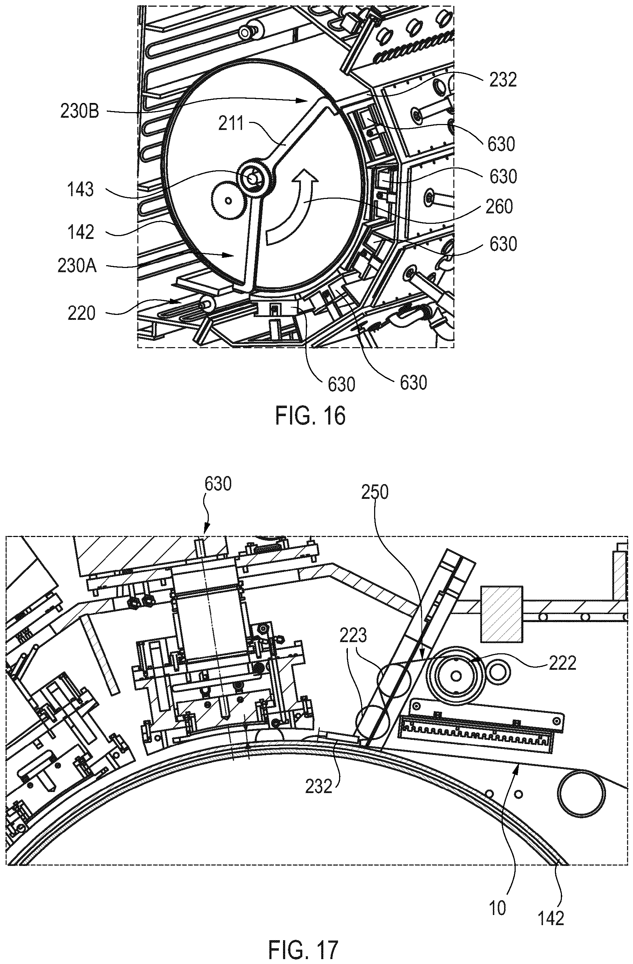

FIG. 13 shows a schematic perspective view of a part of the process chamber of the vacuum processing system according to embodiments described herein, including a shutter device 200 configured to move a shielding foil 250 between the process drum 142 and the one or more deposition sources. As exemplarily described with respect to FIG. 6, the one or more processing components, e.g. deposition sources, of the vacuum processing system may be positioned with a gap being present between the process drum 142 and the one or more processing component. For example, the gap may have a width of about 0.5 mm to 50 mm. According to some embodiments, which can be combined with other embodiments described herein, the shutter device 200 can include at least one first portion, e.g. the first portion 231 shown in FIG. 15, and at least one second portion, e.g. the second portion 232 shown in FIG. 15, as described in more detail with respect to FIGS. 15 and 16. The first portion may provide a rotation axis of the shutter device 200. The shielding foil 250 may be connectable to the second portion, for instance by at least one of clamping, gripping, gluing, magnetic forces, soldering and welding. The shielding foil 250 may also be referred to as "jalousie". The shutter device 200 may also be referred to as "jalousie shutter".

By a rotation about the rotation axis, the shielding foil 250 attached to the second portion can be moved between the process drum 142 and the one or more deposition sources. For better understanding, in FIG. 14 a simplified representation of a deposition source 630 is illustrated. When the shielding foil 250 covers the areas underneath the deposition source, a plasma cleaning method may be conducted. The shielding foil 250 can be moved by an automatic actuation, for instance at the beginning of an initiated cleaning sequence.

According to some embodiments, which can be combined with other embodiments described herein, the shutter device 200 may be positioned underneath (below) the process drum 142. The shielding foil 250 can be moved from below the process drum 142 in an upward direction to be positioned between the process drum 142 and the one or more deposition sources. By positioning the shutter device 200 underneath the process drum 142, a number of apparatus parts, particularly moving apparatus parts, above the process drum 142 can be minimized. Further, particles released from the shutter device 200 and/or the shielding foil 250 fall for instance to the bottom of the process chamber without reaching or crossing the deposition zone. Accordingly, a contamination of the deposition process with impurities and particularly of the coated layers can be prevented. According to some implementations, the shielding foil is resistant against cleaning substances, so that the shielding foil is re-useable, i.e. the shielding foil does not need to be replaced after a cleaning process.

According to some embodiments, which can be combined with other embodiments described herein, the apparatus may include at least one spacer device provided e.g. at a side of the process drum 142 (see e.g. spacer device 225 in FIGS. 13 and 14). In some embodiments, one spacer device 225 at each side of the process drum 142 may be provided. The spacer device 225 may be circular or may be a part of a circle, wherein a diameter thereof may be greater than a diameter of the process drum 142. The spacer device 225 may be configured to support the shielding foil 250, particularly when the shielding foil 250 is moved between the process drum 142 and the one or more deposition sources. The spacer device 225 may provide a gap between the process drum 142 or the flexible substrate disposed thereon and the shielding foil 250. Accordingly, a risk of damage of the process drum 142 or the flexible substrate can be minimized, since the shielding foil 250 does not touch the process drum 142 or the flexible substrate when the shielding foil 250 is moved between the process drum 142 and the one or more deposition sources.

In some other implementations, the shutter device 200 may not include the spacer device 225 and the shielding foil 250 may touch or contact the process drum 142 or the flexible substrate disposed thereon when the shielding foil 250 is moved between the process drum 142 and the one or more deposition sources. In this case, the shielding foil 250 and the process drum 142 carrying the flexible substrate are moved at the same velocity. In other words, there may be substantially no relative movement of the shielding foil 250 with respect to the process drum 142.

FIG. 14 shows a schematic side view of a process drum of a vacuum processing system including a shutter device according to embodiments described herein. According to some embodiments, which could be combined with other embodiments described herein, the shutter device 200 can include at least one arm, e.g. arm 230, having at least one first portion, e.g. first portion 231, and at least one second portion, e.g. second portion 232. The first portion 231 may provide a rotation axis of the arm 230. The apparatus may have one first portion 231 provided at one of the sides of the process drum 142, or may have two first portions 231, one on each side of the process drum 142. The shielding foil 250 may be connectable to the second portion 232, for instance by at least one of clamping, gripping, gluing, magnetic forces, soldering and welding.

By rotating the arm 230 about the rotation axis defined by the first portion 231, the shielding foil 250, which is attached to the second portion 232, can be moved between the process drum 142 and the deposition source 630, and can particularly be moved within the above mentioned gap provided between the process drum 142 and the deposition source 630. For example, in the case that an etching process may be initiated, the arm 230 can move around the rotation axis 143 of the process drum 142 and transport the attached shielding foil 250 around the process drum 142.

According to some embodiments, which can be combined with other embodiments described herein, the rotation axis of the arm 230 is substantially parallel to a rotation axis 143 of the process drum 142. Particularly, the rotation axis of the arm 230 may correspond to the rotation axis 143 of the process drum 142. In some implementations, the first portion 231 may be attachable to the rotation axis 143 of the process drum 142 to be rotatable about said rotation axis 143. In some embodiments, a bearing such as a bush bearing or a roller bearing can be provided for providing the arm 230 to be rotatable. For instance, the arm 230, and particularly the first portion 231, can be attached to the rotation axis 143 of the process drum 142 via the bearing such as a bush bearing or a roller bearing.

In some implementations, the first portion 231 can extend substantially perpendicular to the rotation axis 143, and could particularly extend from the rotation axis 143 of the process drum 142 at least to a circumferential surface thereof. A length of the first portion can be at least equal or greater than a diameter of the process drum 142.

According to some embodiments, which can be combined with other embodiments described herein, the second portion 232 may extend substantially parallel to the rotation axis 143 of the process drum 142, and may particularly extend along at least a part of the circumferential surface of the process drum 142. In some implementations, the second portion 232 may extend along substantially the whole length of the circumferential surface of the process drum 142. In some implementations, the second portion 232 can extend from the first portion 231.

According to some embodiments, which can be combined with other embodiments described herein, the first portion 231 could extend along a first direction and the second portion 232 could extend along a second direction, the second direction being possibly substantially perpendicular to the first direction. In some implementations, the first direction could be substantially perpendicular to the rotation axis 143 of the process drum 142, and/or the second direction could be substantially parallel to the rotation axis 143 of the process drum 142.

Although in principle it might be possible to move shielding means perpendicular to the direction of the flexible substrate transport to cover and protect the process drum during a cleaning procedure, in this case the curvature of the process drum and the curvature of the shielding foil are not parallel in a transport direction. The shielding foil would have to be bent in the width direction of the shielding foil. However, when the shielding foil is rolled up onto a roller like roll reception 220, the shielding foil would get bent in length direction of the shielding foil. Thus, a stiff material like a shielding foil made of metal may be destroyed.

In FIG. 15 a shutter device 200 having an arm 230 with two first portions 231 and one second portion 232 connecting the two first portions 231 is shown. The first portions 231 may be disposed on opposing sides of the process drum 142. In other words, one first portion 231 could be provided on each side of the process drum 142. The first portion 231 may include a bore or center bore 233 configured for providing a connection with an axis or shaft, for instance with the rotation axis 143 of the process drum 142. Associated with the center bore 233 may be a bearing (not shown) such as a bush bearing or a roller bearing, so that the first portion 231 is rotatable. As an example, the bearing could be disposed within the center bore 233 or could be provided to surround the center bore 233.

According to some embodiments, which can be combined with other embodiments described herein, the shutter device 200 may include a drive configured to move the shielding foil 250 between the process drum 142 and the one or more deposition sources 630. In some implementations, the drive can be configured to rotate the arm 230 about the rotation axis provided by the first portion 231. According to some embodiments, the drive may include a motor such as an electric motor and/or pneumatic motor.

In some implementations, the drive can be connected to the first portion 231 via a gear assembly. The gear assembly may include a first gear wheel 234 provided at the first portion 231. As an example, the first gear wheel 234 could be provided to at least partially surround the rotation axis defined by the first portion 231, particularly the center bore 233. The gear assembly may also include a second gear wheel 235 directly or indirectly connected to a drive mechanism, such as a motor, e.g., an electric motor and/or pneumatic motor.

According to some embodiments, which can be combined with other embodiments described herein, the shutter device 200 may include one or more roll receptions 220 configured for winding and/or unwinding the shielding foil 250. The one or more roll receptions 220 are configured for receiving the shielding foil 250, and particularly for receiving or holding a roll having the shielding foil 250 wound thereon. Accordingly, the roll with the shielding foil 250 can easily be replaced when necessary. In some embodiments, a first end portion of the shielding foil 250 is connectable to the roll reception. As an example, the first end portion of the shielding foil 250 may be connectable to the roll reception 220, and a second end of the shielding foil 250 may be connectable to the second portion 232 of the arm 230.

According to some embodiments, which can be combined with other embodiments described herein, the one or more roll receptions 220 can be provided within the process chamber. Also the shielding foil 250 can (for instance completely) be provided within the processing chamber and is not provided outside thereof. In view of this, there is no need to guide the shielding foil from the outside into the processing chamber, for instance through a vacuum lock. This facilitates cleaning the processing chamber without breaking the vacuum in the processing chamber.

However, in other implementations, the at least one roll reception can be provided outside the processing chamber. In such a case, the shielding foil 250 could be supplied from the outside into the processing chamber e.g. through an air lock. In this configuration, still the first end portion of the shielding foil 250 may be connectable to the roll reception 220, and the second end of the shielding foil 250 may be connectable to the shutter device, particularly the second portion 232 of the arm 230.

In some implementations, at least one of the one or more roll receptions 220 can be provided below the process drum 142. By positioning one or more roll receptions 220 underneath the process drum 142, particles released from the one or more roll receptions 220 and/or the shielding foil 250 fall for instance to the bottom of the process chamber without reaching or crossing the deposition zone. In view of this, a contamination of the deposition process and particularly of the coated layers with impurities can be prevented.

According to some embodiments, which can be combined with other embodiments described herein, the roll reception 220 may include a reception portion 222 configured for receiving the shielding foil 250 or a roll with the shielding foil 250, and particularly for receiving a roll having the shielding foil 250 wound thereon.

In typical implementations, the roll reception 220 may have at least one attachment portion, e.g. attachment portion 221 in FIG. 15. The attachment portion 221 may be configured to provide a rotatable connection between the reception portion 222 or the roll with the shielding foil 250 and the processing chamber. The reception portion 222 may particularly be mounted within the processing chamber via the at least one attachment portion. As an example, the attachment portion 221 may include or be connectable to a bearing such as a bush bearing and/or a roller bearing for providing the rotatable connection. In some embodiments, the attachment portion 221 may be configured such that at least the reception portion 222 is rotatable about a rotation axis. The rotation axis of the reception portion 222 may be substantially parallel to the rotation axis of the process drum. In typical implementations, the reception portion 222 may have two attachment portions 221, one on each side of the reception portion 222.

In other embodiments, the roll reception may include the attachment portions, and may not include the roll reception. The roll reception may include at least two independent, e.g. non-connected, attachment portions. The roll receptions may particularly include two attachment portions. The attachment portion may be configured to be connectable to a roll having the shielding foil 250 wound thereon, and may particularly be configured to be connectable to a side of the roll having the shielding foil 250 wound thereon. The attachment portion may be configured to provide a rotatable connection between the roll with the shielding foil 250 and the processing chamber. To this end, the attachment portion may include or be connectable to a bearing such as a bush bearing and/or a roller bearing.

In some implementations, the shielding foil 250 is provided on the roll reception 220, and a first end of the shielding foil 250 is connected to a second portion 232 of a shutter arm 210. When the shutter arm 210 rotates about the rotation axis 143, the shielding foil 250 is unwound or unrolled from the roll reception 220 and is moved between the process drum 142 and the one or more deposition sources 630, and is particularly moved within a gap between the process drum 142 and the one or more deposition sources 630, as described in more detail with respect to FIG. 16.

FIG. 16 shows a detailed perspective view of the processing portion of a vacuum processing system as described herein including a shutter device. In particular, in FIG. 16 two exemplary different positions of the shutter device are shown. For instance, during a deposition process, the arm 230 of the shutter device 200 may be in a first position 230A. In the first position 230A, the shielding foil 250 is not disposed between the process drum 142 and the deposition sources 630. As an example, in the first position 230A, the shielding foil 250 may be in a wound or rolled up state. For moving the shielding foil 250 between the process drum 142 and the deposition source 630, the arm 230 may move or rotate (indicated with arrow 260) from the first position 230A into a second position 230B. Particularly, by moving the arm 230, the shielding foil 250 is unwound, unrolled or uncoiled from roll reception 220.

In some implementations, the roll reception 220 may include a retraction mechanism, for instance a spring-based retraction mechanism, which provides a force opposing the movement of the shielding foil 250 and/or arm 230, and particularly opposing the movement of the shielding foil 250 and/or arm 230 from the first position 230A into the second position 230B. Accordingly, the shielding foil 250 may take the tension, so that shielding foil can be guided between the process drum 142 and the deposition sources 630, particularly without wrinkling and/or without being entangled for instance between the process drum 142 and the deposition sources 630.

When the arm 230 is moved back from the second position 230B into the first position 230A, for instance after a cleaning process has been completed, the shielding foil 250 can be rewound or recoiled on the roll reception 220. In some implementations, the roll reception 220 may include the above mentioned retraction mechanism. Accordingly, the shielding foil 250 can be coiled up, particularly in a tensed state so that no wrinkling and/or entangling occurs.

According to some embodiments, which can be combined with other embodiments described herein, the roll reception 220 may not include the retraction mechanism but may include a drive such as a motor for re-winding the shielding foil 250 on the roll reception 220.

According to some embodiments, which can be combined with other embodiments described herein, the arm 230 may be configured to rotate about at least 90°, particularly 130°, 140°, 143°, 150° or 180°. In other words, an angle or rotation angle between the first position 230A and the second position 230B may be about at least 90°, and may particularly be 130°, 140°, 143°, 150° or 180°.

In view of the above, the shielding foil 250 may cover areas underneath the deposition sources 630, and plasma cleaning can take place without affecting the flexible substrate and/or the process drum 142. Accordingly, there is no need to break the vacuum before cleaning, since the shutter device 200 can move the shielding foil 250 to protect the process drum 142 during the cleaning process even when the processing chamber is sealed and evacuated. Further, the embodiments described herein allow to perform a cleaning process such as a NF3 cleaning process without removing the flexible substrate e.g. from the plasma clean region. Accordingly, an in-situ chamber cleaning can be provided such that purging and venting the chamber for removing the flexible substrate is not necessary.

FIG. 17 shows a plan view of the processing portion of an apparatus for processing a flexible substrate according to embodiments described herein. According to some embodiments, which can be combined with other embodiments described herein, the first end portion of the shielding foil 250 may be connectable to the roll reception, particularly to the reception portion 222, and a second end of the shielding foil 250 may be connectable to the second portion 232 of the arm. In some implementations, one or more guide rollers or deflection rollers 223 for guiding or deflecting the shielding foil 250 could be provided between a position of the roll reception and the second portion 232. The deflection rollers 223 could be configured to provide a defined angle between a tangent of a circumferential surface of the process drum 142 and a surface of the shielding foil 250. As an example, the defined angle may be a flat angle. As shown in FIG. 17, a flexible substrate 10 can be disposed on the process drum 142. The shutter device can be configured to move the shielding foil 250 between the deposition sources 630 and the flexible substrate 10, and can particularly be configured to move the shielding foil 250 within a gap between the deposition sources 630 and the flexible substrate 10. Accordingly, there is no need to remove the flexible substrate 10 from the processing chamber prior to starting a cleaning process such as a plasma cleaning process, since the flexible substrate 10 is protected from the cleaning substances such as NF3 and SF6.

In view of the above, it is to be understood that various methods may be performed by the embodiments of the vacuum processing system as described herein. In particular, it is to be understood that embodiments of the vacuum processing system as described herein provide for various possible methods with respect to: operating the vacuum processing system, processing a substrate (e.g. depositing a multilayer structure), cleaning the process chamber etc.

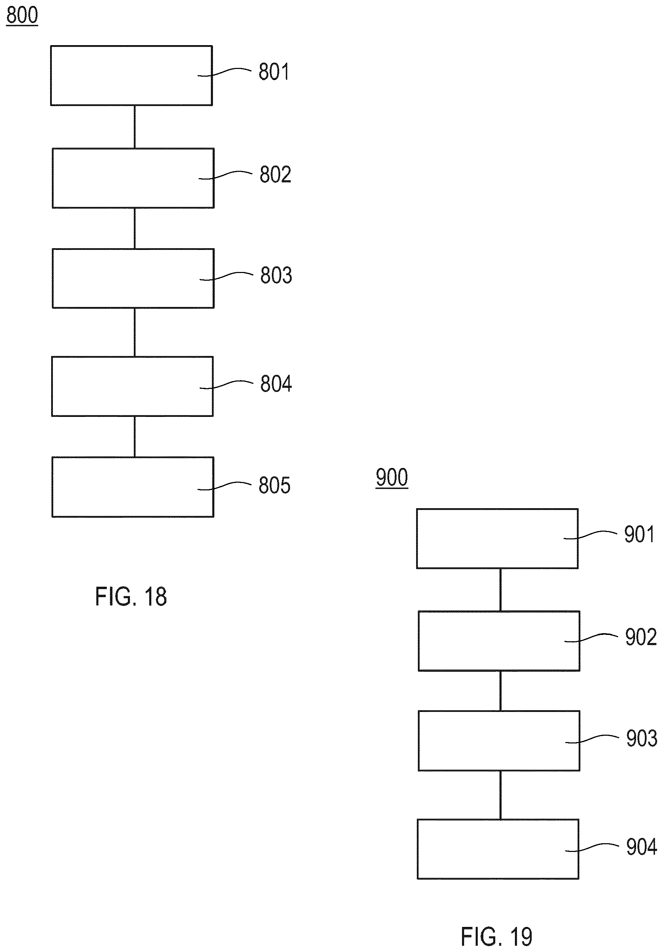

For example, FIG. 18 shows a block diagram illustrating a method 800 for cleaning a process chamber 140 of a vacuum processing system 100 according to embodiments described herein. In particular, according to embodiments, the method for cleaning a process chamber 140 is adapted for cleaning the process chamber without breaking the vacuum in the process chamber. In particular, the method 800 for cleaning a process chamber may include guiding 801 a shielding foil between a process drum and one or more deposition sources 630 by a shutter device 200; initiating 802 a first pump and purge process in the process chamber 140; providing 803 a cleaning or etching gas to the process chamber 140; plasma cleaning 804 the process chamber; and initiating 805 a second pump and purge process in the process chamber.

Further, according to embodiments which can be combined with other embodiments described herein, guiding 801 the shielding foil 250 between the process drum 142 and the one or more deposition sources 630 may include: guiding the shielding foil within a gap provided between the process drum 142 or the flexible substrate 10 disposed thereon and the one or more deposition sources 630, particularly without touching the process drum 142 or the flexible substrate 10 disposed thereon.

FIG. 19 shows a block diagram illustrating a method of depositing at least two layers on a flexible substrate. According to embodiments, method 900 of depositing at least two layers on a flexible substrate, particularly using a vacuum processing system according to embodiments described herein, may include: guiding 901 the flexible substrate over an outer surface of a process drum; providing 902 a separation gas at at least two positions at opposing sides of at least a first deposition source; providing 903 a process gas and exhausting the process gas between the at least two positions; and pumping 904 at at least one vacuum outlet between the first deposition source and a at least one second deposition source. According to some implementations, the separation gas can be hydrogen, nitrogen or a noble gas. Additionally or alternatively, the pressure at the at least one vacuum outlet can be smaller than the pressure in any area of the first deposition source and the at least one second deposition source, e.g. the first processing region and the second processing region.

In view of the above, it is to be understood that significant demands exist in terms of winding different types and thicknesses of substrate within the same production tool. The tension applied to the substrate during winding (transport) may dramatically differ depending upon the tensile yield, substrate temperature and substrate thickness. Accordingly, embodiments of the present disclosure are equipped with online tension measurement and control systems to ensure stable substrate transport through the processing system as described herein, e.g. a deposition system. Further, it should be noted that mechanical contact between both transport rollers (e.g. the guide rollers as described herein) and tension rollers (e.g. the tension measurement roller and the spreader as described herein), and the coated substrate (e.g. at the front surface of the substrate as described herein) is intentionally eliminated, to reduce the risk of both scratch formation and particulate inclusion. As described herein, embodiments of the present disclosure provide for an optimized winding path (also referred to a substrate transportation path) to ensure a minimum level of backside contact which can be beneficial for reducing the defect creation rates arising from substrate conveyance.

Further, it is to be understood that embodiments described can be used for multilayer deposition. In particular, the multilayer deposition capability is provided for by employing an active gas separation system, e.g. a gas separation unit as described herein, for processing components such as deposition sources (e.g. CVD, PVD, or PECVD) or etching devices. According to embodiments which may be combined with other embodiments described herein, high density plasma source technologies can be implemented, for example with excitation frequencies greater than 2 MHz. Accordingly, it is to be understood that embodiments as described herein are configured to ensure efficient power coupling to the plasma at low thermal budget. Further, the skilled person understands that embodiments as described herein are particularly configured for high quality inorganic layer processing. In particular, it should be noted that embodiments described herein are configured for liquid precursor handling which permits the deposition of multilayer structures utilizing a variety of different precursors to effectively tune resultant layer properties. Further, embodiments described herein provide for uptime advantages, for example by using fluorinated gases for in-situ plasma cleaning to remove side-wall deposits, eliminating the need to open the tool to the atmosphere for cleaning and maintenance at the end of each process run.

From the present disclosure, it will be understood that embodiments as described herein provide inter alia for a multi-region, high rate deposition source (e.g. a PECVD source) for dynamic coating, a process and device for in-situ cleaning (e.g. of a PECVD source), an adjustable gas separation, which may be integrated into the deposition source (e.g. the PECVD source) for minimum distance between two adjacent deposition sources, a platform scaling for various coating widths, a system architecture with modular components, a possibility to form a single drum (SD) configuration to double drum (DD)-configuration, source orientation with deposit up architecture for particle management, excellent accessibility for substrate feed in/out between coating drums, and an integrated load/unload system.

Additionally, from the present disclosure, it will be understood that embodiments as described herein provide for an improved winding system, also referred to as substrate transport arrangement herein. In particular, embodiments as described herein provide inter alia for no roller contact with the front/layer side of the substrate to be processed, a fixed (permanently installed) winding system with high roller parallelity and winding accuracy, separation of un-winder/re-winder (also referred to as supply roll and take-up roll herein) enabling a separate pumping and venting to reduce particle contamination risk, and a web guide control (also referred to as substrate guide control unit herein) with only two rollers used for tension measurement and alignment.

Further, it should be noted that the embodiments of the vacuum processing system as well as the method performable by the vacuum processing system as described herein provide for improved manufacturing of various devices including thin films, particularly on a flexible substrate. For example, the vacuum processing system provides for deposition layers or a stack of layers for thin film barriers, particularly ultra-high barrier stacks or flexible TFT devices. Ultra-high barrier stacks or flexible TFT devices are typically composed of a series of layers, which are typically deposited with PECVD or PVD processes or combinations thereof. Because of the high demands on the quality of the different films, it is common use to deposit the single films in specially designed systems for each single film. To bring down costs and make the applications commercially available, the vacuum processing system as described herein provides for an improvement by combining the deposition of at least sets or combinations of films in one single coater. Further, the modular concept of the vacuum processing system allows the combination of several process modules (e.g. a first process module including a first process chamber, a second process module including a second process chamber, an un-winding module, a winding module, and an interleaf module). Moreover, embodiments described herein provide for improved process gas separation with a separation factor being significantly higher as compared to prior systems, and particularly even for variations of different processes being conducted on the same apparatus. In light of the above, according to some embodiments described herein, flexible ultra-high barriers for OLED display and/or lighting, flex solar, or other electronic devices with the need for protection from an adjacent environment can be provided. For example, this can include the deposition of etch stop, gate dielectric, channel, source gate and drain electrodes for flexible TFT.

Further, it is to be understood that embodiments as described herein, beneficially can be used and configured for new display applications (e.g. displays for mobile devices) driven by form factors such as shape, size, weight, unbreakability etc. Moreover, embodiments described herein provide for high throughput low cost manufacturing, particularly by providing a R2R processing system as described herein. In view of the above, the skilled person understands that embodiments described herein are configured for various applications such as cover lens applications (e.g. hard coats, AR layer stacks, etc.), touch screen applications (e.g. ITO Film TP, metal mesh, etc.), display applications (e.g. barrier films for quantum dot, OLED displays, etc.) and electronic applications (e.g. TFT Backplanes, particularly with < 200 ppi).

In particular, it is to be understood that embodiments described herein provide for R2R CVD applications for scratch resistant coatings on "cover glass" replacements, R2R CVD applications for PT HardCoat and optical coatings and touch panels, R2R CVD applications for display front plane encapsulation, and R2R CVD applications for TFT backplanes and substrate ultra-high barriers (UHB).

For example, embodiments described herein may be employed for manufacturing touch panels including SiOₓ (e.g. for a hard coat, a low index optical layer, etc.) and/or SiNₓ (e.g. for a high index optical layer). Further, embodiments described herein may be employed for manufacturing ultra-high barriers including SiOₓ (e.g. for a substrate barrier, a device barrier, etc.) and/or SiNₓ (e.g. for a substrate barrier, a device barrier, etc.). Moreover, embodiments described herein may be employed for manufacturing flexible TFT displays barriers including a-Si:H (e.g. for a channel layer a-Si, ELA-precursor for LTPS, etc.) and/or µ-Si:H (e.g. for a N+ contact layer for a-Si TFT) and/or SiOₓ (e.g. for a etch stop layer, a gate dielectric for IGZO, etc.) and/or SiNₓ (e.g. for a gate dielectric).

## Claims

1. A vacuum processing system (100) for a flexible substrate (10), the vacuum processing system comprising:
a first chamber (110) adapted for housing a supply roll (111) for providing the flexible substrate (10);
a second chamber (120) adapted for housing a take-up roll (121) for storing the flexible substrate (160) after processing;
a substrate transport arrangement including one or more guide rollers (104) for guiding the flexible substrate (10) from the first chamber (110) to the second chamber (120);
a maintenance zone (130) between the first chamber (110) and the second chamber (120) wherein the maintenance zone (130) allows for maintenance access to or of at least one of the first chamber (110) and the second chamber (120); and
a first process chamber (140) for processing the flexible substrate (10),
wherein the first process chamber (140) comprises at least one deposition source (630), wherein the at least one deposition source (630) includes a microwave antenna (700) comprising a first group (711) of slots and a second group (712) of slots, and wherein the first group (711) of slots is arranged on a different radial position along the length of the microwave antenna (700) compared to the second group (712) of slots.

2. The vacuum processing system (100) according to claim 1, further comprising a passageway (150) connecting the first process chamber (140) to the second chamber (120) or to a second process chamber (240), wherein the passageway (150) is provided above or below the maintenance zone (130), particularly wherein the passageway, the first chamber (110) and the second chamber (120) encompass the maintenance zone (130).

3. The vacuum processing system (100) according to claim 2, wherein the second process chamber (240) is located so that the second chamber (120) is provided between the maintenance zone (130) and the second process chamber (240).

4. The vacuum processing system (100) according to any of claims 2 to 3, wherein at least one of the first process chamber (140) and the second process chamber (240) comprises:
- a process drum (142) having an outer surface for guiding the substrate (10) through a first vacuum processing region and at least one second vacuum processing region, wherein the process drum (142) has a rotation axis (143) extending in a first direction, and
wherein the at least one deposition source (630) is arranged at a height of or below a horizontal center line of the first process chamber (140) or the second process chamber (240), respectively, in particular at the height of or below the rotation axis (143) of the process drum (142) of the first process chamber (140) or of the second process chamber (240).

5. The vacuum processing system (100) according to any of claims 2 to 4, wherein at least one of the first process chamber (140) and the second process chamber (240) comprises a first part (146) providing one or more deposition sources and a second part (147) allowing a communication with the passageway (150) of the vacuum processing system, wherein the first part (146) and the second part (147) are connected along a line inclined with respect to a vertical direction.

6. The vacuum processing system (100) according to claim 4 or 5, wherein a heating device (131) adjacent to the process drum (142) is provided, wherein the heating device (131) is configured for spreading the substrate (10), particularly in a direction perpendicular to a substrate transport direction (108), or for maintaining a spread of the substrate, particularly in a direction perpendicular to the substrate transport direction (108), and wherein the heating device has a dimension in a direction parallel to the substrate transport direction (108) of at least 20 mm.

7. The vacuum processing system (100) according to claim 6, wherein the heating device (131) is positioned between the process drum (142) and a spreader roller (144), wherein the spreader roller (144) is a first roller to touch the substrate upstream or downstream of the process drum (142).

8. The vacuum processing system (100) according to claims 6 or 7, further comprising a heat adjustment unit, wherein the heat adjustment unit (133) is positioned opposing a first side of the heating device (131), and wherein the heat adjustment unit (133) and the heating device form a gap or a tunnel providing a path for the flexible substrate (10).

9. The vacuum processing system (100) according to claims 4 to 8, wherein the at least one deposition source (630) has a curved surface, wherein the curved surface of the at least one deposition source is shaped such that the at least one deposition source has an essentially parallel surface with respect to the surface of the process drum (142).

10. The vacuum processing system (100) according to any of claims 1 to 9, wherein the microwave antenna (700) comprising an elongated sleeve (720) with a plurality of slots (710) provided along a length of the microwave antenna (700), the plurality of slots (710) comprising the first group (711) of slots and the second group (712) of slots.

11. The vacuum processing system (100) according to any of claims 1 to 10, further comprising a substrate guide control unit (300) for guiding a substrate, the substrate guide control unit (300) comprising a single guide roller (104), wherein the single guide roller (104) comprises
- an adjustment unit (310);
- a first substrate tension measurement unit (301) and a second substrate tension measurement unit (302) for measuring the tension of the substrate (10) at a first end and a second end of the guide roller (104) with the second end being opposite the first end; and
- a data connection (311) for supplying the measured tension from the first end of the guide roller (104) and the measured tension on the second end of the guide roller to a controller (501) for controlling the adjustment unit (310).

12. The vacuum processing system (100) according to any of claims 4 to 11, wherein the at least one deposition source (630) comprises:
- an electrode (602) having a surface, wherein the surface of the electrode opposes the outer surface of the process drum (142);
- a processing gas inlet (612) and a processing gas outlet (614), wherein the processing gas inlet and the processing gas outlet are arranged at opposing sides of the surface of the electrode; and
- at least one separation gas inlet (1842) having one or more separation gas inlet openings, wherein the one or more separation gas inlet openings are at least provided at one of opposing sides of the surface of the electrode (602) such that the processing gas inlet (612) and/or the processing gas outlet (614) are provided between the one or more separation gas inlet openings and the surface of the electrode.

13. The vacuum processing system (100) according to any of claims 4 to 12, further comprising an actuator (374) configured for adjusting a distance between the at least one deposition source (630), particularly an electrode of the at least one deposition source, and the outer surface of the process drum (142).

14. The vacuum processing system (100) according to any of claims 4 to 13, further comprising a gas separation unit (370) for separating the first vacuum processing region from the at least one second vacuum processing region adapted to form a slit (20) through which the substrate (10) can pass between the outer surface of the process drum (142) and the gas separation unit (370), wherein the gas separation unit (370) is adapted to control fluid communication between the first vacuum processing region and the second vacuum processing region, and wherein the fluid communication is controlled by adjusting a position of the gas separation unit (370).

15. A method (900) of depositing at least two layers on a flexible substrate using a vacuum processing system according to any of claims 1 to 14, comprising:
guiding (901) the flexible substrate over an outer surface of a process drum;
providing (902) a separation gas at at least two positions at opposing sides of at least a first deposition source;
providing (903) a process gas and exhausting the process gas between the at least two positions; and
pumping (904) at at least one vacuum outlet between the first deposition source and a at least one second deposition source.
